# EUROPEAN PATENT SPECIFICATION

(11) **EP 1 405 356 B1**
(45) Date of publication and mention of the grant of the patent: **31.07.2013**
(21) Application number: 02751302.7
(22) Date of filing: 09.07.2002
(51) Int. Cl.: H01L 51/40, H01L 51/05

(54) **SOLUTION INFLUENCED ALIGNMENT**
LÖSUNGSMITTELBEEINFLUSSTE AUSRICHTUNG
ALIGNEMENT INFLUENCE PAR UNE SOLUTION

(30) Priority: 09.07.2001 GB 0116735; 14.01.2002 GB 0200643; 03.04.2002 GB 0207713
(43) Date of publication of application: 07.04.2004
(73) Proprietor: Plastic Logic Limited, Cambridge CB4 0FX (GB)
(72) Inventor: SIRRINGHAUS, Henning, Coton, Cambridge CB3 7PW (GB); ARIAS, Ana, Claudia, Cambridge CB4 3NF (GB); MACKENZIE, John, Devin, Cambridge CB4 3NF (GB)
(74) Representative: Slingsby, Philip Roy
(86) International application number: PCT/GB2002/003132
(87) International publication number: WO 2003/007397

(56) References cited:
- WO-A-01/17040
- WO-A-01/47045
- JP-A- 2001 108 829
- CONBOY J C ET AL: "IMPACT OF SOLVENT VAPOR ANNEALING ON THE MORPHOLOGY AND PHOTOPHYSICS OF MOLECULAR SEMICONDUCTOR THIN FILMS" JOURNAL OF PHYSICAL CHEMISTRY. B, MATERIALS, SURFACES, INTERFACES AND BIOPHYSICAL, WASHINGTON, DC, US, vol. 102, no. 23, 4 June 1998 (1998-06-04), pages 4516-4525, XP000964644 ISSN: 1089-5647

## Description

This invention relates to forming aligned polymer layers, especially aligned polymer layers suitable for use in devices such as polymer thin film transistors. The aligned polymers are preferably substantially parallel aligned, liquid-crystalline conjugated polymers.

Semiconducting conjugated polymer field-effect transistors (FETs) have potential applications as key elements of integrated logic circuits (C. Drury, et al., APL 73, 108 (1998)) and optoelectronic devices (H. Sirringhaus, et al., Science 280, 1741 (1998)) based on solution processing on flexible plastic substrates. One main criterion to obtain high charge carrier mobilities has been found to be a high degree of structural order in the active semiconducting polymer.

For some polymers it is known to be possible to induce uniaxial alignment of the polymer chains in thin films by using processing techniques such as Langmuir Blodgett (LB) deposition (R. Silerova, Chem. Mater. 10, 2284 (1998)), stretch alignment (D. Bradley, J. Phys. D 20, 1389 (1987)), or rubbing of the conjugated polymer film (M. Hamaguchi, et al., Appl. Phys. Lett. 67, 3381 (1995)). Polymer FET-devices have been-fabricated with uniaxially aligned polymer films-fabricated by stretch alignment ((P. Dyreklev, et al., Solid State Communications 82, 317 (1992)) and LB deposition (J. Paloheimo, et al., Thin Solid Films 210/211, 283 (1992)). However, the field-effect mobilities in these studies have been low (< 10⁻⁵ cm²/Vs).

Local order in thin polymer films can be achieved by making use of the pendency of some polymers to self-organise. An example is poly-3-hexylthiophene (P3HT) in which lamella-type ordered structures can be formed by phase segregation of rigid main chains and flexible side chains. By using suitable deposition techniques and chemical modification of the substrate it is possible to induce preferential orientations of the ordered domains of the polymer with respect to the substrate surface. At present P3HT yields the highest known field-effect mobilities of 0.05-0.1 cm²/Vs for polymer FETs (H. Sirringhaus, et al., Science 280, 1741 (1998)). In these known devices there is no preferential, uniaxial alignment of the polymer chains in the plane of the film.

Some conjugated polymers and small molecules exhibit liquid-crystalline (LC) phases. By definition, a liquid-crystalline phase is a state of matter in which the molecules have a preferential orientation in space. This alignment is conventionally regarded as being alignment with respect to a vector called the director. Unlike in the solid, crystalline state the positions of the molecules in the LC phase are randomly distributed in at least one direction. Depending on the type of orientational and residual positional order one distinguishes between nematic, cholesteric and smectic LC phases. The nematic phase possesses long-range orientational order but no positional order. Smectic phases are characterized by a two-dimensional (2D) layered structure, in which the molecules self-assemble into a stack of layers each with a uniform orientation of the molecules with respect to the layer normal, but either no positional order or a reduced degree of positional order in the 2D layers. LC phases occur mainly in polymers / molecules with a significant shape anisotropy. Examples of conjugated LC polymers are main-chain polymers with a rigid-rod conjugated backbone and short flexible side chains, so-called hairy-rod or rigid-rod polymers. Examples are poly-alkyl-fluorenes (M. Grell, et al., Adv. Mat. 9, 798 (1998)) or ladder-type poly-paraphenylenes (U. Scherf, et al., Makromol. Chem., Rapid. Commun. 12, 489 (1991)). Another type of LC polymers are side-chain polymers with a flexible nonconjugated backbone and rigid conjugated units in the side chains.

LC phases typically occur at elevated temperatures in the undiluted organic material (thermotropic phases) or if the organic material is dissolved in a solvent at a sufficiently high concentration (lyotropic phases) (see, for example, A.M. Donald, A.H. Windle, Liquid Crystalline Polymers, Cambridge Solid State Science Series, ed. R.W. Cahn, E.A. Davis, I.M. Ward, Cambridge University Press, Cambridge, UK (1992)).

LC polymers can be uniaxially aligned by suitable processing techniques. In an aligned sample the orientation of the director, that is, for example, the preferential orientation of the polymer chains in a main-chain LC polymer, is essentially uniform over a macroscopic distance of > µm-mm. This is the scale of practical channel lengths in FET devices. Alignment can be induced by shear forces or flow or by depositing the LC polymer onto a substrate with an alignment layer exhibiting a uniaxial anisotropy in the plane of the substrate. The alignment layer may be a mechanically rubbed organic layer such as polyimide (M. Grell, et al., Adv. Mat. 9, 798 (1998)), a layer evaporated at an oblique angle onto the substrate, or a layer with a grooved surface. For a review of the various techniques which can be used to align LC molecules see for example, J. Cognard, J. Molec. Cryst. Liq. Cryst. Suppl. Ser. 1,1 (1982).

JP 2001/281661 A2 discloses using a lyotropic liquid crystal layer to induce alignment in a small molecule liquid crystal material.

A particularly attractive technique is photoalignment which is less prone to mechanical damage than rubbing. A photosensitive polymer is polymerized by exposure with linearly polarized light. The plane of polarization of the light defines a preferential orientation of the chains of the photosensitive polymer. Such layers can be used as alignment layers for a broad range of polymer and small molecule liquid crystals (M. Schadt, et al., Nature 381,212 (1996)).

Uniaxially aligned liquid-crystalline polymers have been incorporated as active light-emissive layers into polymer light emitting diodes to produce linearly polarized light (M. Grell, et al., Adv. Mat. 9, 798 (1998); G. Lüssem, et al., Liquid Crystals 21, 903 (1996)).

EP 0786 820 A2 discloses the device structure of an organic thin film transistor (TFT) in which the organic semiconducting layer is in contact with an orientation film, such as a rubbed polyimide layer. The orientation film is intended to induce alignment of the organic semiconducting layer when the latter is deposited on top of the.orientation film. However, for most organic semiconducting materials, in particular for conjugated polymers processed from solution, mere deposition onto an orientation film is not sufficient to induce alignment in the organic semiconductor.

In UK 9914489.1 a method is demonstrated by which high charge carrier mobilities can be obtained by using a polymer semiconductor with a liquid crystalline phase. The device configuration developed in UK 9914489.1 allows uniaxial alignment of the polymer between the source-drain electrodes of the transistor by making use of an alignment layer such as a mechanically rubbed or photoaligned polyimide. The uniaxial alignment of the polymer chains parallel to the direction of current flow in the device makes optimum use of the fast intrachain transport along the polymer backbone. If the polymer is thermotropic the polymer can be brought into its liquid crystalline phase by annealing at elevated temperature, and the orientation of the chains can be preserved by quenching the sample to room temperature.

One of the preferred technological processing criteria for polymer TFTs is that all processing steps should be performed at relatively low temperatures: preferably below 100-150 °C. This is to avoid distortions of flexible plastic substrates that could occur when fabricating TFT circuits at higher temperatures.

For many rigid-rod conjugated polymers, that exhibit liquid crystalline organisation, such as poly-9,9'-dioctylfluorene-co-dithiophene (F8T2), the transition temperature for the melting of the bulk solid polymer into the LC phase, occurs at high temperatures. In the case of F8T2 the thermotropic LC transition is around 265°C as measured by differential scanning calorimetry (DSC). This temperature is typical for many rigid rod polymers, but it is too high for use on typical cheap, plastic substrates. As an illustration, in order to be compatible with polyethyleneterephtalate alignment of LC polymers at temperatures of less than 120 - 150°C is required.

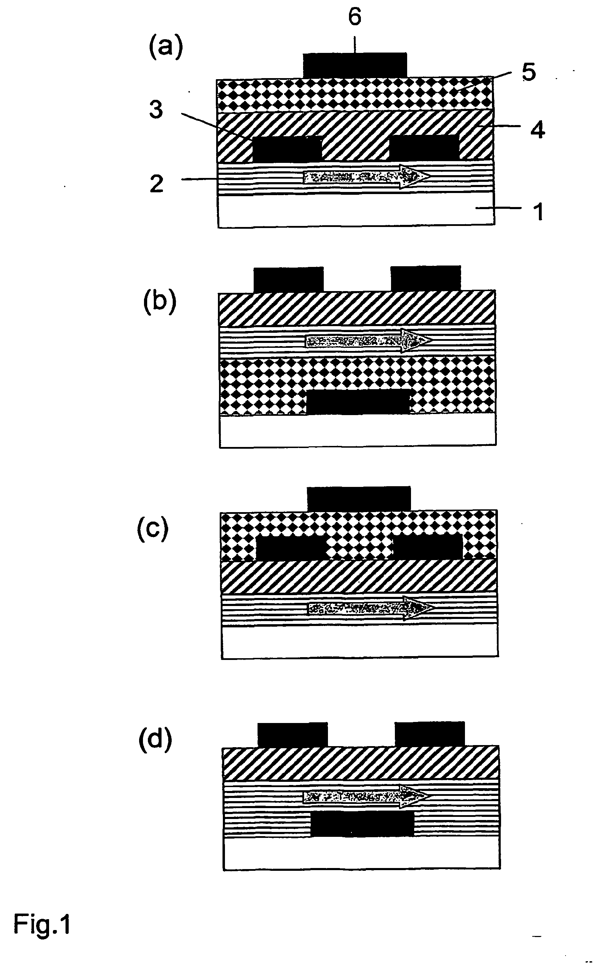

In WO 01/077045 a method is described by which all-polymer thin film transistors can be fabricated by direct inkjet printing (Fig. 1 (a)). To achieve patterning of source-drain electrodes with spatial resolution of a few µm's, a surface free energy pattern is first fabricated on the substrate, which can then be used to confine the spreading of droplets of a conducting ink resulting in accurate channel definition. The formation of source-drain electrodes is then followed by coating of thin films of semiconducting and insulating layers and by inkjet printing deposition of the gate electrode. In one of the preferred device configurations disclosed in WO01/047045 the layer that defines the hydrophobic-hydrophilic surface energy pattern is used also as an alignment layer to induce uniaxial alignment of the liquid crystalline semiconducting polymer layer. In one embodiment of the invention the surface energy layer consists of a layer of hydrophobic polyimide deposited on top of a hydrophilic glass substrate. The polyimide layer is rubbed mechanically such that the chains of the LC polymer align parallel to the rubbing direction on top of the surface energy barrier that defines the channel of the TFT. One of the requirements for the surface energy barrier / alignment layer is that it has sufficiently high glass transition temperature, in order to provide a strong alignment torque onto the LC polymer at the temperature that is required to bring the polymer into its liquid crystalline phase. In the case of F8T2 the thermotropic melting temperature is high, limiting the choice of materials that can be used as alignment layers.

According to the present invention there is provided a method for forming an aligned polymer layer according to claim 1.

In one embodiment, bringing the polymer into alignment comprises annealing the film at a temperature below the melting temperature of the polymer in isotropic bulk, and cooling the film.

The step of solidifying the film preferably comprises allowing the solvent to evaporate from the film. The time to evaporate the solvent from the film is preferably longer than 5 minutes, more preferably longer than 30 minutes, and may be longer than 60 minutes.

Preferably the step of bringing the polymer into alignment comprises contacting the film with an alignment substrate having a surface relief capable of inducing alignment in the polymer. Such surface relief may be formed by rubbing the substrate.

Preferably the step of solidifying the film comprises exposing the film to a vacuum to encourage the solvent to evaporate from the film. The solvent is preferably evaporated under vacuum..

Preferably the temperature of annealing is more than 10°C, or alternatively more than 25°C, or most preferably more than 50°C below the melting temperature of the polymer in isotropic bulk.

Preferably the temperature of annealing is less than 180°C.

Preferably the step of annealing the polymer film comprises melting or heating the polymer film from its free surface.

Preferably the polymer is deposited from a solution in a solvent in which the radius of gyration of the polymer is larger than the radius of gyration of the polymer in its theta solvent. It will be appreciated that the theta solvent of a polymer is a theoretical solvent.

Solidifying the film by removing the solvent from the film may be performed before or after the alignment step.

One technique comprises: bringing a solution of the polymer dissolved in a solvent into contact with a substrate; and depositing the layer on the substrate by progressively adsorbing molecules of the polymer from solution on to the substrate in the presence of a field capable of inducing alignment in the polymer; and separating the substrate from the solution. The layer may be deposited epitaxially or mesoepitaxially on to the substrate. The solution of the polymer is lyotropic and preferably supersaturated. The solvent is preferably a solvent in which the radius of gyration of the polymer is smaller than the radius of gyration of the polymer in its theta solvent. The solubility of the polymer in the solvent is preferably less than 10g/l at room temperature. Preferably during the step of depositing the layer of the polymer the solution is maintained at a temperature above that at which nucleation of the polymer occurs in the bulk of the solution. Preferably during the step of depositing the layer of the polymer the solution is heated more strongly from its side facing the free surface than from the side facing the substrate.

In one embodiment, the polymer has an electrically conductive or semiconductive main chain, wherein the chains of the polymer have an electrically conductive or semiconductive charge-transporting end-group at each end thereof, and the polymer in the layer is organised in a lamellar structure having ordered regions, in which the polymer main chains are aligned with respect to each other, and boundary regions which separate the ordered regions and in which the degree of alignment between adjacent polymer main chains is less than that in the ordered regions.

The average distance between adjacent charge transporting end groups in the boundary regions is preferably less than 5 nm, and most preferably less than 2 nm.

The thickness of the boundary regions may be less than 100 nm, and more preferably less than 20 nm.

The main chain of the polymer is preferably conjugated. The polymer is preferably a rigid rod polymer. The polymer is preferably a polyfluorene-based homo- or block- copolymer. The polymer is a liquid crystalline polymer. The polydispersity of the polymer is preferably less than 2.5, and more preferably less than 1.5.

The difference between the ionisation potential of the end groups and the ionisation potential of the polymer main chain is preferably less than 0.4 eV, and more preferably less than 0.2 eV.

The difference between the electron affinity of the end groups and the electron affinity of the polymer main chain is preferably less than 0.4 eV, and more preferably less than 0.2 eV.

The end groups of the polymer may independently contain any of the following units: a thiophene unit, a benzene unit, a pyrrole unit, a furan unit, an oligoaniline unit or a triarylamine unit. The end-groups of the polymer preferably do not contain flexible alkyl side chains.

In one embodiment the method is a method for forming an electronic switching device such as a field-effect transistor. Preferably the field-effect mobility of the device is larger than 10⁻² cm^{2/}Vs.

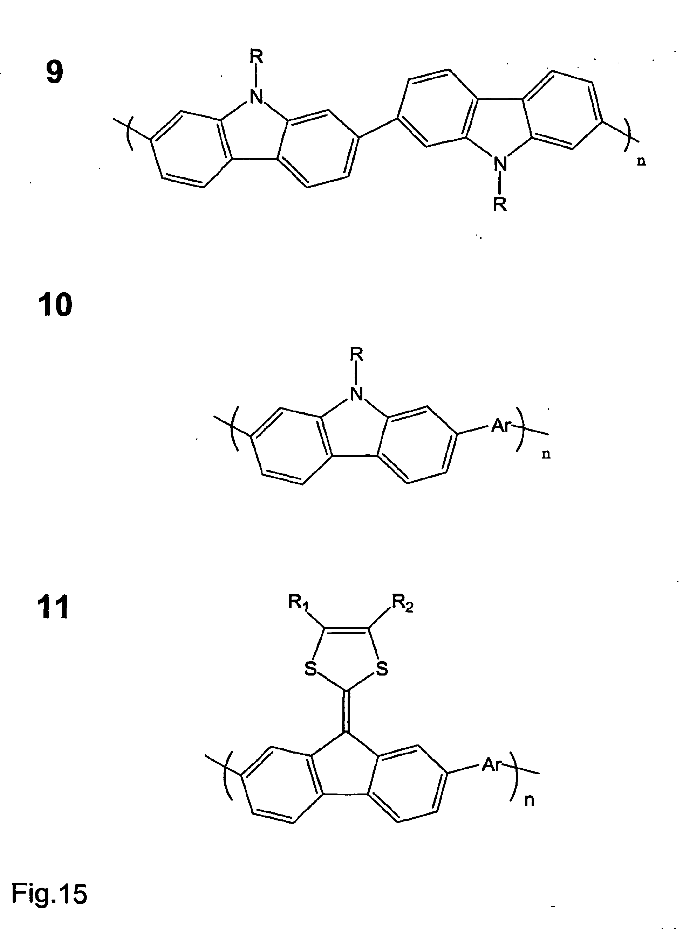

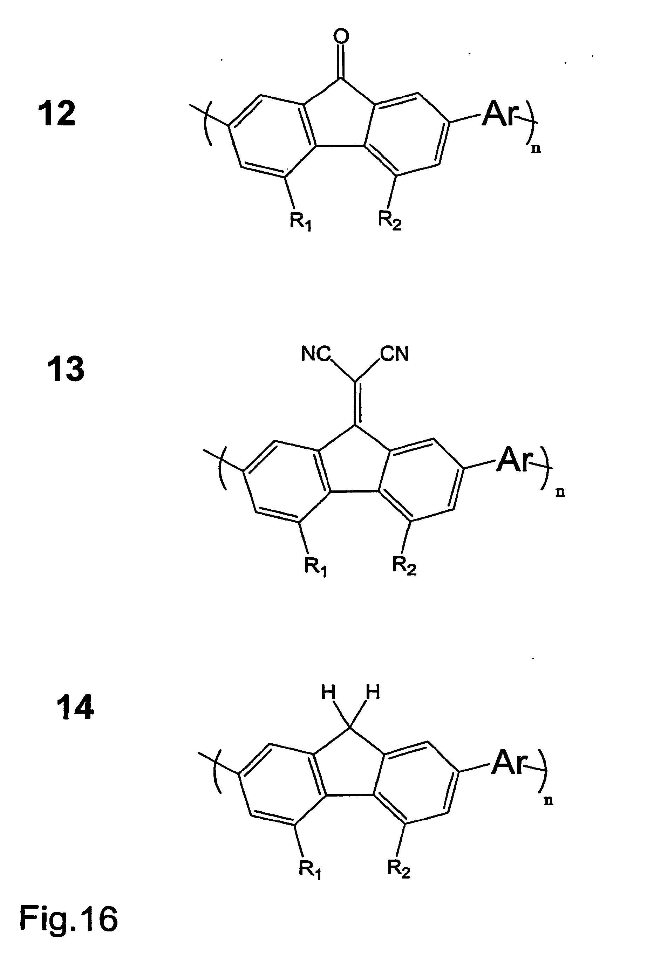

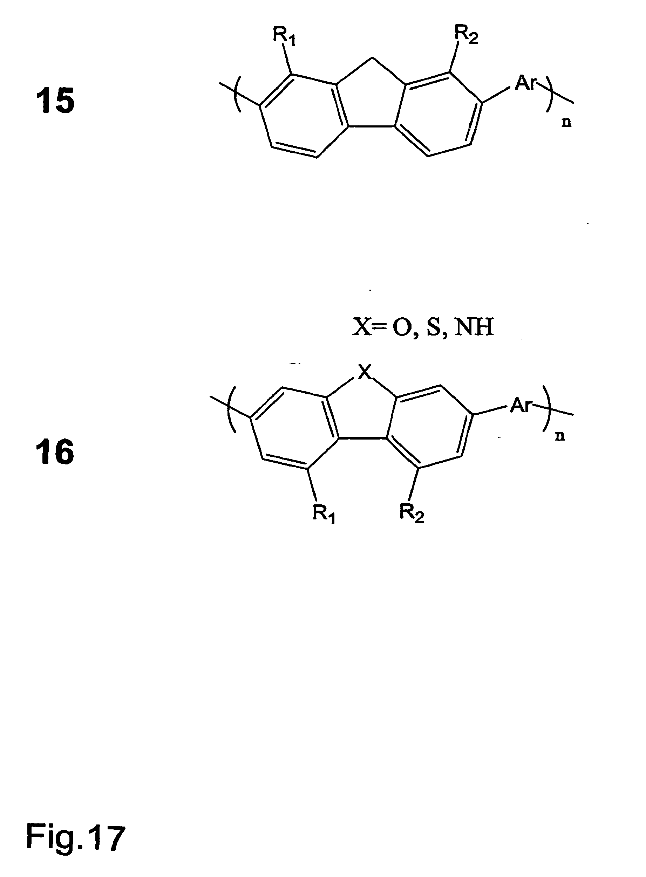

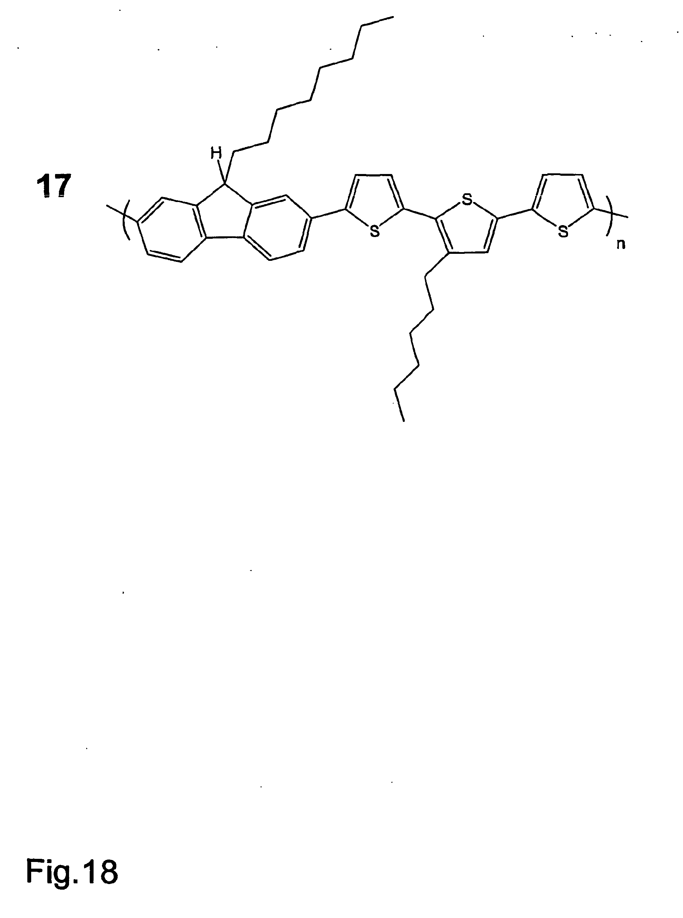

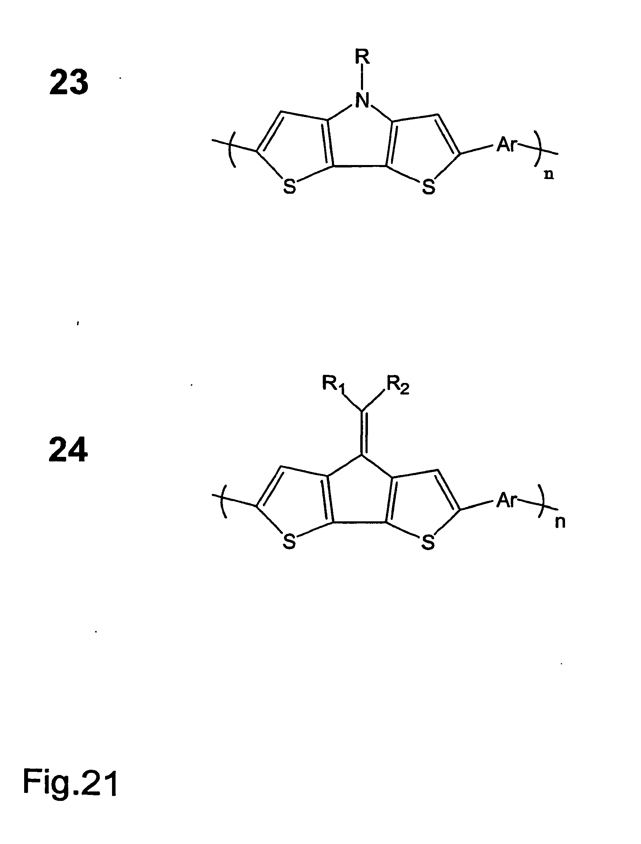

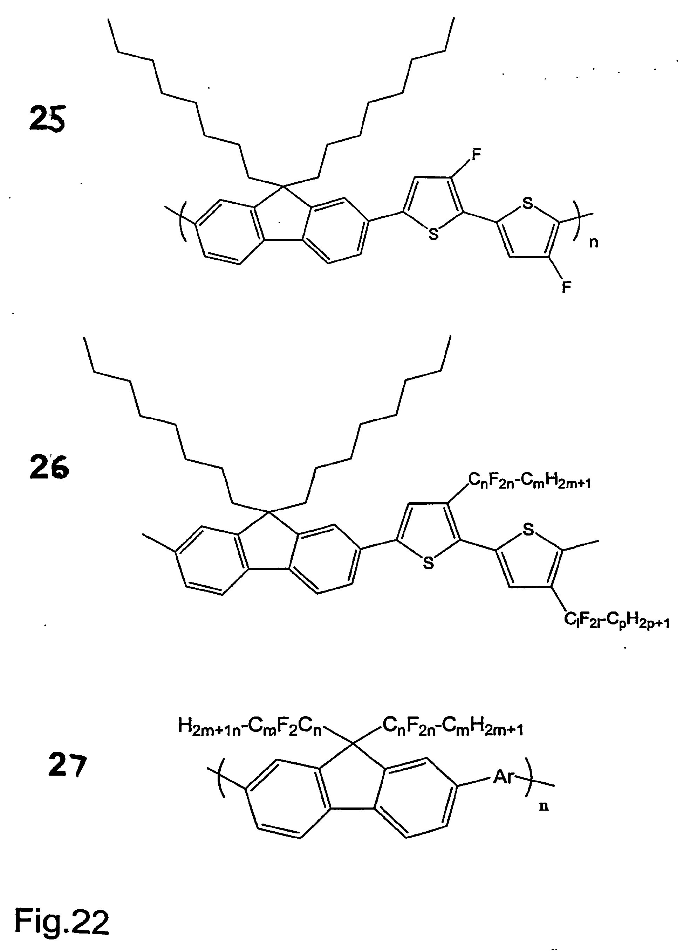

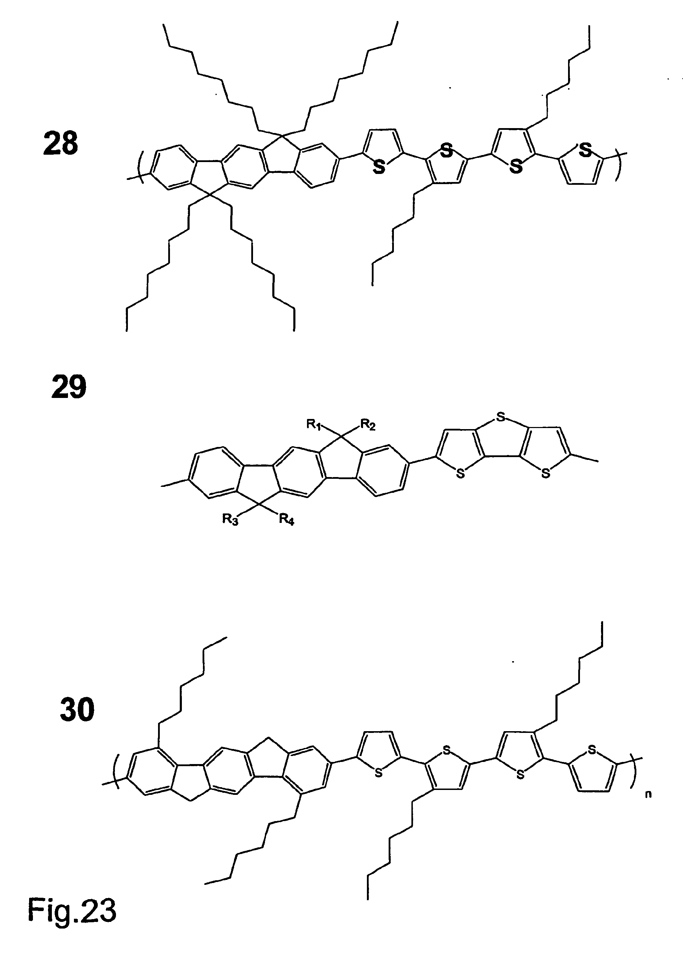

According to one embodiment, the aligned polymer layer forms an active region of a field feel transistor and the polymer is as shown in any of figures 15 to 23, wherein: n is an integer larger than 1; and R, R1, R2, R3 and R4 may be the same or different in each monomer unit in the polymer and are independently selected from hydrogen, alkyl groups or alkoxy groups; and Ar is an aromatic or heteroaromatic hole transporting or electron transporting block. The hydrogen, alkyl or alkoxy groups may optionally be substituted with one or more fluorine atoms. The alkyl or alkoxy groups may be branched or linear, and may be saturated or unsaturated.

The transistor preferably has two or more electrodes whereby a potential may be applied across the region of the polymer. Preferably the polymer is aligned in the said region. Preferably the region is a conductive or semiconductive region of the transistor.

circuit, display or memory device formed by a method as set out above. A technique according to

the present invention allows uniaxial alignment of rigid-rod polymer semiconductors in transistor devices at temperatures that are significantly below the melting transition temperature into the thermotropic liquid crystalline phase. In particular, a technique is demonstrated that allows uniaxial alignment at room temperature.

According to one embodiment, a LC polymer is aligned at low temperatures on top of a surface energy barrier / alignment layer that had been patterned and photoaligned by exposure to a focussed beam of linearly polarised light.

According to one embodiment, a semiconducting LC polymer is deposited by printing from solution onto an alignment layer and acquires an aligned molecular structure upon drying of the solvent.

According to one embodiment, the deposition of a semiconducting polymer is confined by a surface energy pattern that is formed by the source and drain electrodes. In this way the parasitic source-drain contact resistances are reduced.

one embodiment,a rigid rod polymer with properties that are optimised for use in TFT devices.

Where the alignment is induced by contacting the film with a substrate having a surface relief capable of inducing alignment in the polymer, such surface relief may preferably be brought about by rubbing the substrate prior to contacting the substrate with the film.

The alignment is preferably liquid crystal alignment throughout the polymer layer, but alternatively local alignment in the layer may also be beneficial. The alignment may be mutual alignment of the polymer chains with each other and/or with an alignment vector that coincides with an applied alignment field.

The solvent is preferably one in which the polymer is soluble. However, where compatible with the other features disclosed herein, the solvent may be one in which the polymer is not soluble, and which simply induces swelling of the polymer.

When solvent is removed from the film it is preferably removed so that no solvent remains, or so that substantially no solvent (e.g. less than 0.1 % by weight remains).

The present invention will now be described by way of example with reference to the accompanying drawings, in which:
figure 1 is a schematic diagram of different bottom-gate (b and d) and top-gate (a and c) device configurations for polymer TFTs with uniaxi*ally aligned LC active layers in contact with an alignment layer.
figure 2 shows optical micrographs under crossed polarizers of F8T2 films of high and low molecular weight spin coated from xylene solution on top of a rubbed polyimide layer and annealed at 180°C (30 min) and 150°C (10min), respectively.
figure 3 shows optical micrographs under crossed polarizers of an F8T2 film aligned on top of a rubbed polyimide layer by slow drying of a solution in xylene at 75°C. The cross with double arrows indicates the direction of the linear polarizers with respect to the direction of alignment of polymer chains (min-polarizer direction along the direction of polymer alignment, max - polarizer direction at 45° to the direction of polymer alignment).
figure 4 shows optical micrographs under crossed polarizers of F8T2 films of high and low molecular weight on top of rubbed polyimide layers obtained by slow drying of a solution in a solvent saturated atmosphere at room temperature.
figure 5 shows optical micrographs under crossed polarizers of F8T2 films on top of rubbed polyimide layers obtained by spin coating a solution of F8T2 from a solvent mixture of m-xylene and cyclohexylbenzene (CHB) for different concentrations of CHB.
figure 6 shows the phase diagram of a lyotropic polymer solution
figures 7 and 8 show examples of rigid rod conjugated polymers.
figure 9 (a) shows a schematic cross section of the potential profile in a TFT configuration where the charge injecting electrodes and the accumulation are separated by a thin film of semiconducting material and (b) shows a schematic drawing of the potential profile for hole carriers along the TFT channel in a configuration where the injecting electrode is in direct contact with the accumulation layer.
figure 10 shows schematic diagrams of top-gate TFTs with continuous (a) and patterned (b) active semiconducting layers. In (b) the deposition of the semiconducting layer is confined to the region between the source and drain contacts.
figure 11 shows a schematic diagram of simultaneous photopatteming and photoalignment of a surface energy barrier / alignment layer.
figure 12 shows smectic organisation of a liquid crystalline polymer of well-defined molecular weight with conjugated backbone A, side chains C, and end group B in between source and drain electrode

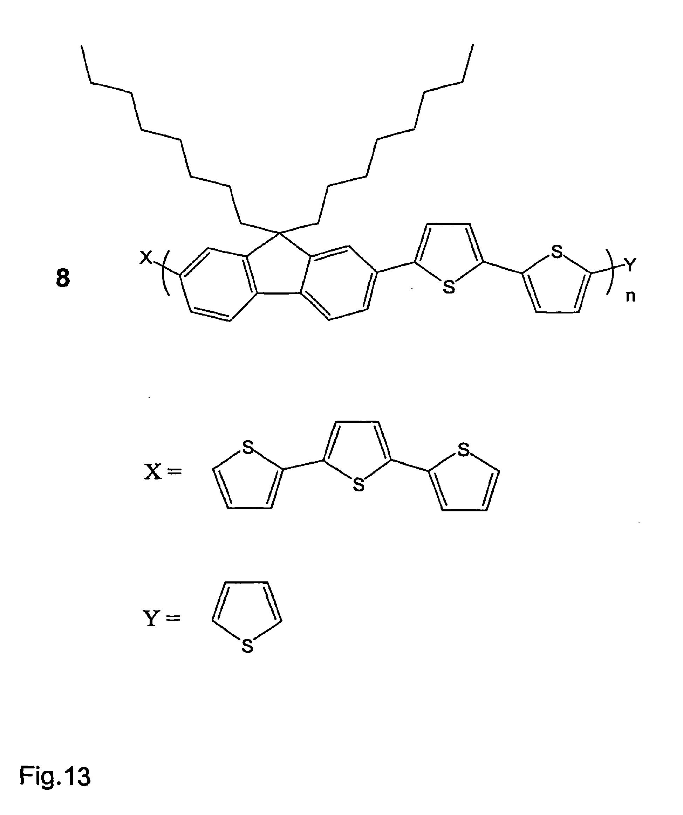

figure 13 shows F8T2 polymer with terthiophene end groups.
figure 14 shows a schematic diagram of a uniaxially aligned rigid rod polymer in between source and drain electrodes with strong π-π interchain interactions in the solid state. The surface of the substrate is functionalised as to attract the side chains of the polymer towards the interface and promote a lamella organisation parallel to the substrate.
figures 15, 16, 17 show rigid rod block copolymers with side chains that are coplanar with the plane of the conjugated backbone promoting close π-π interchain stacking in the solid state.
figure 18 shows a fluorene based copolymer with asymmetric side chain substituents promoting aggregation in the solid state.
figures 19, 20 and 21 show examples of homo- and block copolymers based on cyclopentabithiophene and a rigidified terthiophene based homopolymer (figure 20(d)).
figure 22 shows examples of fluorinated fluorene-based block copolymers.
figures 23 and 24 show examples of hole transporting copolymers based on polyindenofluorene.

For many rigid rod polymers the thermotropic LC transition occurs at temperatures above 150-200°C, i.e. it is too high for use on many plastic substrates. A general method disclosed herein to reduce the thermotropic LC transition temperature is to increase the entropy of the polymer chains in the LC phase. This can be achieved in several different ways. A reduction can be achieved by attaching more flexible side chains to the polymer backbone. It is also important to minimize as much as possible interactions between adjacent polymer chains. Interactions stabilize the crystalline state of the polymer and increase the melting transition temperature. In the case of F8T2 substitution of flexible alkyl side chains at the 3-position of the thiophene rings will result in a reduction of the LC transition temperatures.

Alternatively, the LC transition temperature can be reduced by substituting the end groups of the polymer chain with liquid crystalline units such as a biphenyl or an unsubstituted fluorene unit.

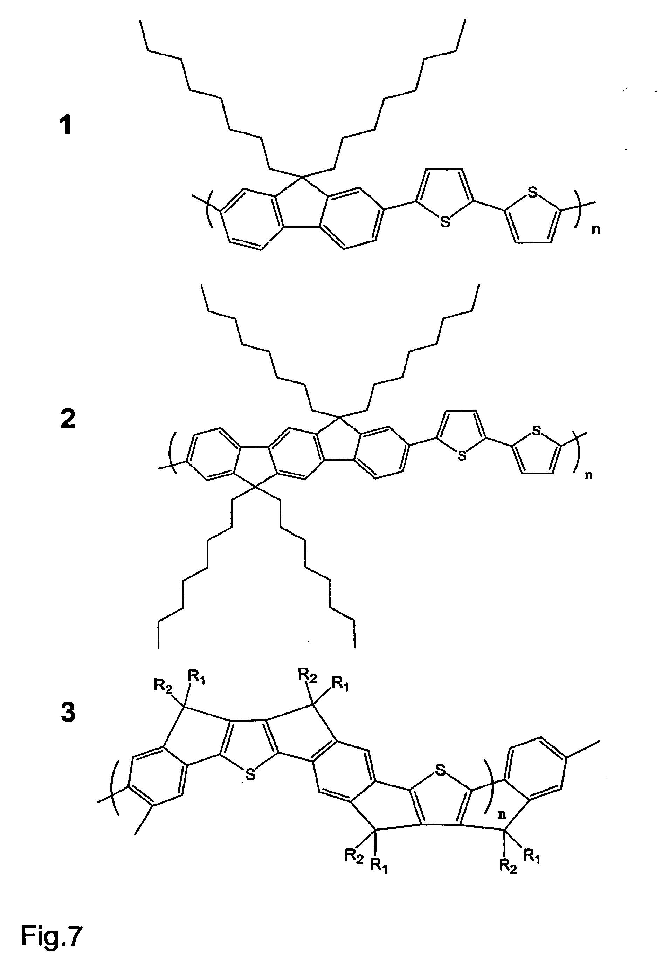

One of the disadvantages of F8T2 (figure 7(1)) is that the molecule is not straight, since the fluorene units are bent away from the in-line catenation by an angle α = 22.8°. This will reduce the persistence length, i.e. the average length scale over which the rigid rod segments of the backbone can be considered straight, and therefore reduce the mobility along the polymer alignment direction. Straightness is considered to be improved in molecules such as F8T3, in which the bending of the fluorene unit is partially compensated by the terthiophene unit. In the aligned state F8T3 shows a higher mobility along the alignment direction. However, F8T3 also shows a higher LC transition temperature, which can again be compensated for by attaching flexible side chains to one or more thiophene rings (figure 7(3)).

In principle, the LC transition temperature may also be decreased by incorporating flexible units such as CₙH₂ₙ at random positions into the main chain. However, the resulting interruption of conjugation is likely to lead to a significant reduction of mobility.

In general, it appears challenging to reduce the thermotropic LC transition temperature of a rigid rod conjugated polymer such as F8T2 or its derivatives to values below 100°C without adversely affecting its charge carrier mobility.

Hereunder there are disclosed several methods by which uniaxially aligned films of LC rigid rod polymers can be fabricated at a temperature of less than 150°C, i.e., significantly below the thermotropic liquid crystalline phase transition temperature.

The first method is based on depositing a thin polymer film from solution onto an alignment layer and annealing the as-deposited film at a temperature below the thermotropic LC transition temperature. Deposition of the film can, for example, be by spin-coating, film casting, screen printing, inkjet printing, or any other thin film solution deposition technique. Surprisingly, it was found that uniaxial alignment of the films occurred at temperatures of 100 °C below the thermotropic LC transition temperature.

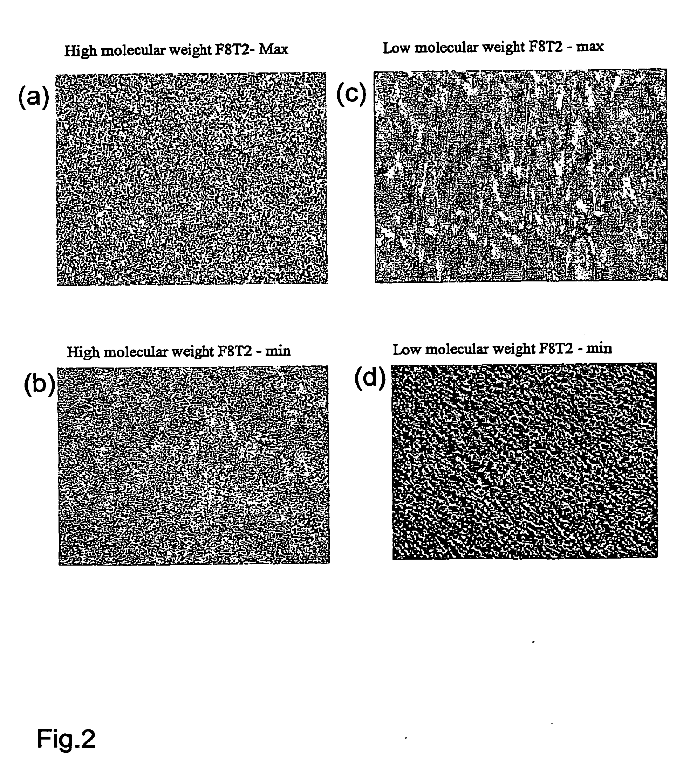

Figure 2 shows optical microscopy images under crossed polarizers of F8T2 films with different molecular weights prepared on a rubbed PI substrate and annealed at temperatures of 150-180°C. These films were deposited by spin coating from a xylene solution with concentration of 7 g/l. This temperature is at least 100°C lower than the thermotropic bulk LC melting transition of 265°C as measured in digital scanning calorimetry (DSC) (H. Sirringhaus et al., Appl. Phys. Lett. 77, 406 (2000)), i.e. the melting temperature of the solution-deposited thin film is lowered by more than 100°C with respect to the bulk polymer. The optical anisotropy observed in the polarised microscopy demonstrates clearly that the low molecular weight F8T2 polymer aligns uniaxially at temperatures as low as 150°C and annealing times as short as 10 min. In contrast the high molecular weight F8T2 films does not align well even at temperatures as high as 180°C and annealing times as long as 30 min.

F8T2 TFT devices were fabricated by the method disclosed in WO01/077045 Absolute mobilities and mobility anisotropies of devices with current flow parallel and perpendicular to the direction of polymer alignment were comparable to those of devices that were annealed at much higher temperatures of 285°C.

F8T2 films of equal film thickness of the lower molecular weight polymer were deposited from a range of different solvents with equal concentrations and aligned by annealing at 150°C. At such low temperatures all films exhibited uniaxial polymer alignment However, significant differences were observed in the degree of alignment. Films deposited from tetrahydrofuran exhibited a high dichroic ratio of 23, whereas films deposited from xylene only had a dichroic ratio of 15. This experiment clearly demonstrates that by careful choice of solvents a high degree of alignment can be achieved at low temperatures.

This surprising result is believed to be due to a combination of different factors. The first factor is believed to be the beneficial effect of entrapped solvent. If the polymer solution is formulated in a solvent that interacts favourably with the polymer, or a particular segment of the polymer, a certain concentration of solvent molecules remains entrapped in the film after drying of the film. The more favourably the solvent interacts with a particular segment of the polymer, for example the side chains of the polymer, and the higher the boiling point of the solvent, the more solvent remains entrapped in the film. This residual solvent results in a reduction of the liquid crystalline melting transition temperature ΔT and the formation of a lyotropic phase upon annealing at low temperatures.

A lyotropic phase is formed in a concentrated solution of the polymer in a solvent. If the concentration exceeds a certain critical value, typically on the order of 0.2 to 0.3, the polymer chains spontaneously organize into an aligned LC phase with polymer chains oriented parallel to each other and solvent molecules filling the space between chains. The role of the solvent is similar to that of the side chains in the case of a thermotropic LC polymer providing the entropy that is necessary to stabilize the LC phase at temperatures below the decomposition temperature of the material. Many high temperature thermotropic polymers show lyotropic phases at low temperatures. Many rigid rod polymers which do not exhibit thermotropic phases below their decomposition temperature due to limited conformational freedom show lyotropic phases.

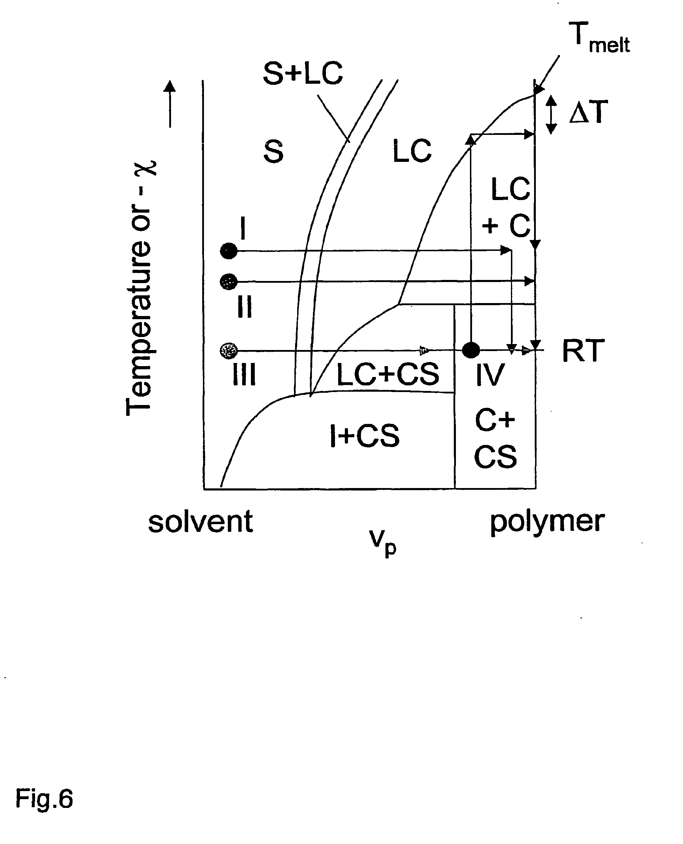

Fig. 6 shows a typical phase diagram of a rigid rod polymer solution exhibiting lyotropic phases (see for example, A.M. Donald, and A.H. Windle, Liquid Crystalline Polymers, Cambridge University Press, Cambridge, UK (1992)). At low concentrations vₚ of the polymer the solution is isotropic at all temperatures. At sufficiently high temperatures there exists a certain critical concentration above which the solution becomes lyotropic. Usually there is a narrow concentration region, the so-called bi-phasic chimney, in which the isotropic phase and the lyotropic LC phase coexist. At even higher concentrations equilibrium with a crystalline phase (C) and/or a crystal solvate phase (CS) is observed. A crystal solvate contains solvent molecules entrapped in a regular lattice. One possible pathway in which a spin-coated, as-deposited film with entrapped solvent can be brought into a lyotropic phase is shown in the phase diagram as pathway IV.

In addition the entrapped solvent also reduces the viscosity of the polymer film, and therefore facilitates the process of aligning the chains from the more disordered microstructure of the as-deposited film. After the alignment process it is possible to remove the entrapped solvent by prolonged annealing at elevated temperature, and/or keeping the film under vacuum.

The second factor are believed to be surface and interface effects that are important in thin films. When the film thickness approaches the typical radius of gyration of the polymer surface effects start to become important. The surface of a film melts at temperatures lower than the bulk melting transition temperature. This is because on the surface of the material fewer bonds need to be broken for meting to occur. On the surface of the film the polymer chains are more mobile, and disentanglement of the complex chain folding of a spin-coated film is facilitated compared to the bulk of a thick film. Therefore, the surface of the film melts into the LC phase at lower temperature than the bulk of the film. In a thin film with a thickness of less than 500-1000 A the melting behaviour of the film is affected by surface effects and the film aligns at a lower temperature than a thick film.

A similar effect is exerted by the interface. The LC transition depends on the surface structure of the alignment layer that is used to induce the uniaxial alignment of the polymer. The more favourable the interaction between the polymer and the alignment layer, for example due to epitaxial or graphoepitaxial growth of the polymer on the alignment substrate the larger the torque exerted by the alignment layer onto the chains at the interface and the lower the temperature for alignment. Examples of suitable alignment layers are mechanically rubbed polymer layers or highly crystalline alignment layers such as friction transferred Teflon or stretch aligned polyethylene.

The third beneficial factor for low temperature alignment is believed to be the conformation of polymer chains in solution. The more extended the chain conformation is, the lower the degree of entanglement in the as-deposited film. A lower degree of entanglement facilitates the alignment process compared to a solid-state conformation in the as-deposited films in which the polymer chains are coiled resulting in a highly entangled microstructure. The radius of gyration, i.e. the degree of chain extension in solution depends, in a complicated way on the interaction between the polymer and solvent molecules (see for example, A.M. Donald, A.H. Windle, Liquid Crystalline Polymers, Cambridge Solid State Science Series, ed. R.W. Cahn, E.A. Davis, I.M. Ward, Cambridge University Press, Cambridge, UK (1992)). However, it can be measured easily for a particular polymer solution by techniques such as light scattering. For a particular molecular weight of the polymer the solvent should be chosen such that the radius of gyration is a large as possible. An extended chain conformation of the polymer in solution is promoted by choosing a good solvent for the polymer. In a bad solvent the polymer chains have a smaller radius of gyration, and there is a tendency of the chains to fold back on themselves in order to avoid contact with the solvent molecules. The crossover from an extended chain to a heavily folded chain is defined by the so-called theta solvent, in which the conformation of the polymer is like a "phantom chain" that undergoes a three dimensional random walk without interacting with either itself nor surrounding solvent molecules. For a given polymer the theta solvent and the radius of gyration can be determined by light scattering experiments (see for example, The Science of Polymer Molecules, Richard H. Boyd and Paul J. Phillips, Cambridge, Cambridge University Press, 1993). The theta solvent is a commonly used & well defined concept, that is well defined experimentally. In practice with a finite number of solvents of choice it might not always be possible to determine exactly the theta solvent at a given temperature, although solvents can always be found that correspond to the theta solvent condition approximately.

A second method that allows alignment at even lower temperatures is based on slow drying of a solution of the polymer on a substrate containing an alignment layer heated to a moderate temperature of typically 50-100°C.

A dilute solution of the polymer in a solvent or a mixture of solvents is deposited onto the TFT substrate containing the alignment layer by techniques such as casting, spin-coating, inkjet printing or other thin film deposition techniques. Before the film is dried, the sample is placed onto a heated stage in a closed atmosphere that allows careful control of the evaporation rate of the solvent. During the slow evaporation of the solvent the concentration of the solution increases. Instead of placing the substrate into a closed atmosphere a high boiling point solvent may be used that only dries slowly at the temperature at which the substrate is held.

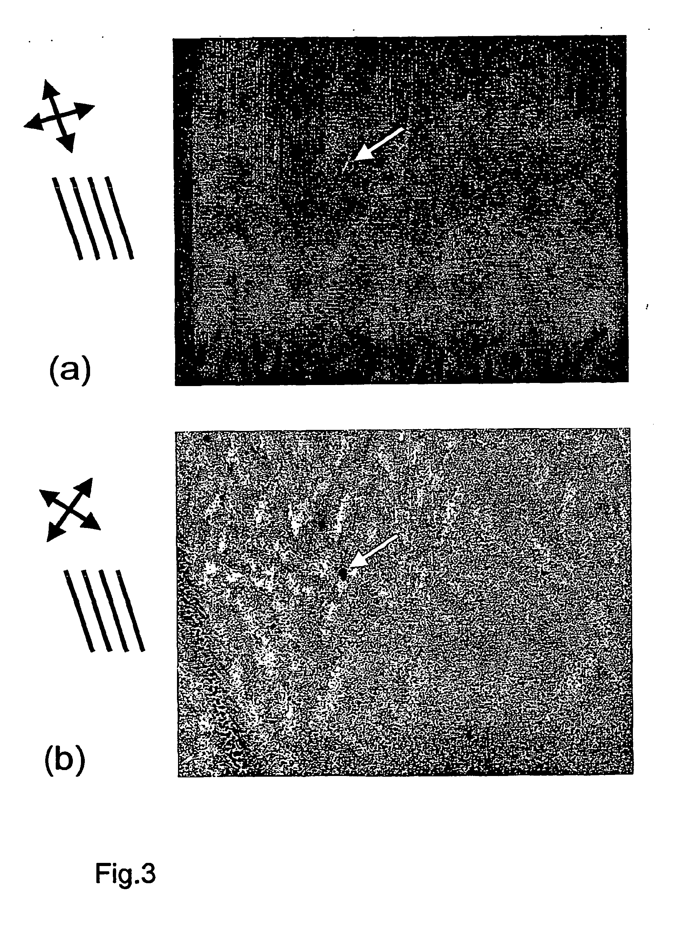

Fig. 3 shows optical microscopy images under crossed polarizers of a dried F8T2 film on a mechanically rubbed polyimide substrate that was deposited from a 1% by weight solution in mixed xylene and kept in a closed atmosphere for a time period of 60 min until the film had dried. The solvent was slowly evaporated at a constant temperature of 75°C in a partially saturated atmosphere of xylene. The polymer is clearly in a uniaxial monodomain configuration. If the polarizers make an angle of ≈ 45° with the alignment direction, the film appears bright under crossed polarizers reflecting the rotation of the plane of polarization of the incident light when passing through the aligned film. If the direction of one of the polarizers is along the alignment direction, the image appears dark. The arrow in Fig. 3 indicates the location of a dust particle as a reference point. This is clear evidence that uniaxial alignment of a rigid rod polymer can be achieved at temperatures below 100°C. O- or p-Xylene was found to be a suitable solvent with a sufficiently high boiling point (138°C) to allow controlled, slow evaporation. of the solvent.

Two mechanisms are believed to be responsible for the alignment in this case. The first one is the formation of a lyotropic phase when the concentration of the drying solution exceeds a certain critical value. It is not necessary that the concentration of the initial solution is higher than the critical value, because the critical concentration is always reached during drying. Several pathways such as pathways I and II in figure 6 can be taken in order to bring the isotropic solution into a lyotropic phase. In the lyotropic phase the polymer chains align spontaneously parallel to the direction imposed by the alignment layer. This orientation is preserved as the film solidifies.

The temperature at which the solution needs to be kept to reach the lyotropic phase can be varied by the choice of solvent. In a good solvent (smaller value of the Flory-Huggins interaction parameter χ) the required temperature is lower than in a bad solvent (positive value of χ). In the latter phase separation into an isotropic solution and a CS phase will be favoured.

In order to achieve good alignment of the polymer chains parallel to the alignment direction of the substrate the nucleation of the crystalline or crystalline-solvate phase from the lyotropic solution needs to be controlled carefully. If aggregates of crystalline polymer or crystalline solvate form in the bulk of the solution at any time during the drying process, in particular before the critical concentration for forming a lyotropic solution is reached, they tend to deposit onto the substrate in a random orientation under the action of gravity. The desired growth mode is one in which the lyotropic solution is supersaturated, i.e. nucleation in the bulk of the solution does not yet occur. At the same time there should be a strongly favourable interaction of the polymer in solution with the surface of the alignment layer, such that polymer chains from solution grow epitaxially or mesoepitaxially on the substrate with chains aligned uniaxially along the direction imposed by the alignment layer.

The templated growth on the substrate can be promoted by the following techniques. At the interface with the alignment layer the interaction of the polymer molecules in solution with the substrate should be more energetically favourable than interaction with surrounding solvent molecules. This can be achieved by depositing the polymer from a relatively poor solvent, and controlling the temperature of the solution carefully. The temperature of the solution needs to be sufficiently high that the polymer does not nucleate in the bulk of the solution, but nucleates only heterogeneously on the substrate. Alternatively, the solution can be subject to a temperature gradient, such that the free surface of the solution is warmer than the interface with the substrate. By carefully controlling the temperature gradient heterogeneous nucleation at the interface with the alignment layer can be induced in this way. Such a temperature gradient can be generated for example by placing a heater above the substrate, as opposed to heating from the substrate side.

The method of making use of a strong favourable interaction of the polymer with the surface of the alignment substrate in order to induce the epitaxial or mesoepitaxial growth of a polymer film off the substrate from a solution in a poor solvent allows uniaxial alignment of a broad range of polymers, including polymers that do not form liquid crystalline phases.

After the solution has dried it is important to remove residual solvent in the film by techniques such as annealing, and/or pumping in vacuum, and/or freeze drying.

In order to control the evaporation rate use of solvent mixtures can be made. By formulating a solution from a mixture of a low boiling point and a high boiling point solvent, the low boiling point solvent will tend to evaporate during the film formation step, leaving behind a concentrated solution of the high boiling point solvent that can then be aligned by the method described above.

There are several advantages of using a lyotropic phase, rather than a thermotropic phase for uniaxial chain alignment. Lyotropic phases form preferentially in polymers with high molecular weight and high persistence lengths. The critical concentration for formation of the lyotropic phase decreases with increasing axial ratio. A high persistence length and high molecular weight are also important for achieving high mobilities.

A third method that allows uniaxial alignment of rigid rod polymers at room temperature is based on slow drying of a lyotropic solution on top of an alignment substrate held at room temperature.

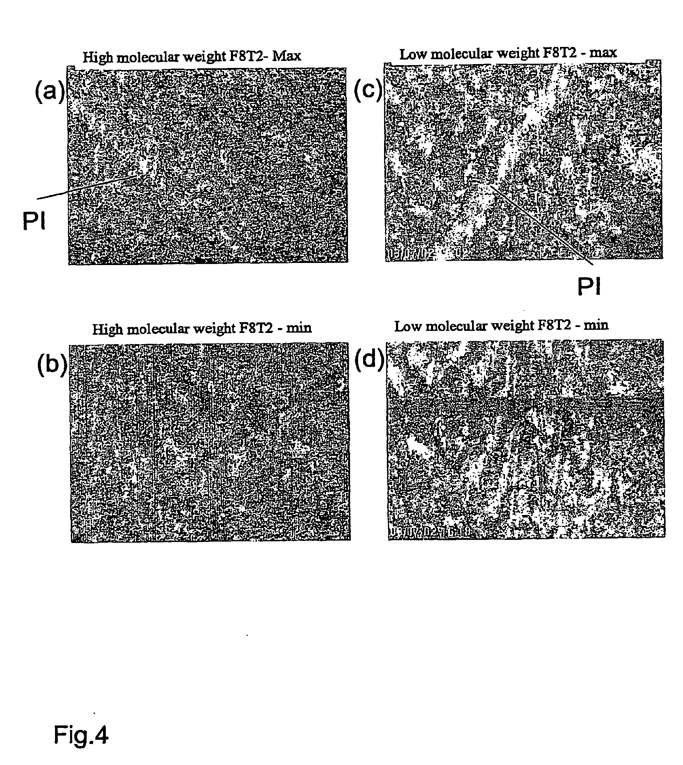

A dilute solution of the polymer in a solvent or a mixture of solvents is deposited onto the TFT substrates by techniques such as spin coating, inkjet printing, drop casting or other film deposition techniques. During the slow evaporation of the solvent, the concentration of the solution on the substrate increases reaching the lyotropic phase which will favour the alignment of the polymer chains. Figure 4 shows optical micrographs under crossed polarizers of dried high and low molecular weight F8T2 films on a glass substrate that contains a narrow line of rubbed polyimide (PI). The films were deposited by drop casting under a solvent saturated atmosphere from 0.7 g/l xylene solutions. Both films were prepared under the same conditions, i.e., the drying time was identical. Cleary both the high and low molecular weight polymer are clearly in a uniaxial monodomain configuration. If the polarizers make an angle of 45 degrees with the alignment direction, the film formed on the PI lines appears bright under cross-polarizers reflecting the rotation of the plane of polarization of the incident light when passing through the aligned film. If the direction of one of the polarizers is along the alignment direction, the image of the PI line appears black. It is also shown 4 that a LC multidomain structure (speckle contrast) is also formed on the glass substrate, but the film is only aligned uniaxially on the rubbed PI lines. This is clear evidence for the existence of a lyotropic phase in F8T2 of a range of molecular weights and demonstrates that in this way uniaxial alignment of the polymer can be achieved at room temperature. In contrast to the method that is based on annealing of as-deposited films the room temperature alignment method allows efficient alignment of polymers with high molecular weight.

Also in this method it is highly desirable that no nucleation of polymer occurs in the bulk of the solution, in particular not at early stages in the drying process, i.e. before the lyotropic phase is formed. Since in this case the solubility of the polymer in the solvent cannot be controlled by the temperature, a relatively good solvent for the polymer needs to be used. We have found m-xylene to be a suitable solvent for room temperature alignment of F8T2.

According to yet another aspect of the present invention a method is disclosed by which aligned polymer films can be obtained by depositing a thin film of polymer from a mixture of a high boiling point solvent and a low boiling point solvent. The mixture can be coated onto the substrate by any thin film deposition technique such as spin coating, blade coating, screen printing or ink jet printing. After deposition of the solution the solvent with the lower boiling point evaporates fast, and leaves behind a concentrated solution of the polymer in the higher boiling point solvent. If during drying of the high boiling point solvent the polymer film is subject to an alignment force, i.e., is deposited on top of an alignment layer or is brought inside a magnetic field, uniaxial alignment of the polymer chains along the alignment direction is obtained. The high boiling point solvent is preferably a good solvent for the polymer in order to avoid aggregation of the polymers in the concentrated solution.

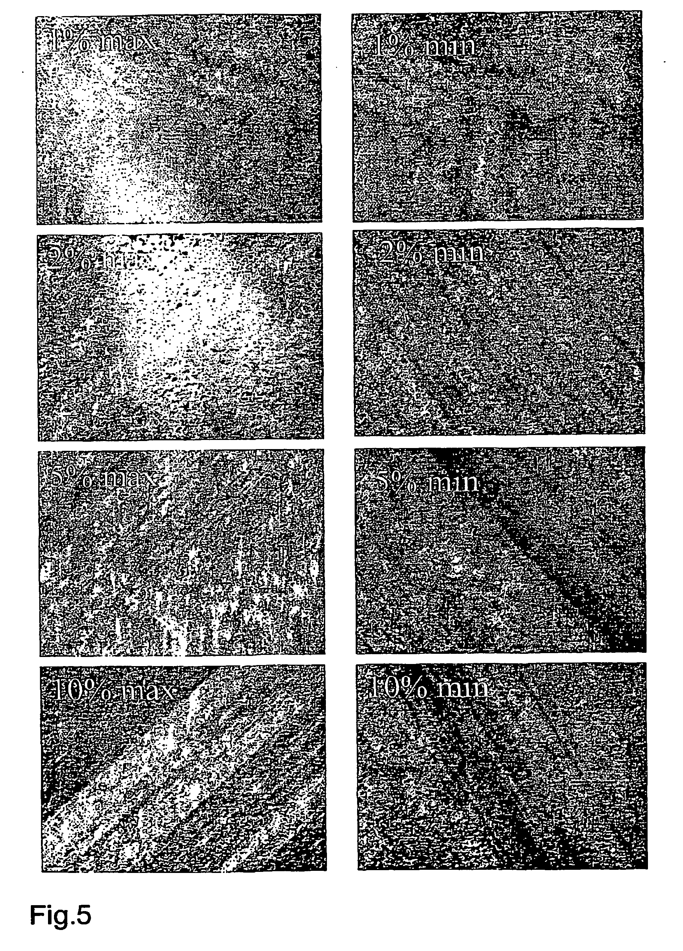

Figure 5 shows optical microscopy images under crossed polarizers of F8T2 films deposited from a mixture of m-xylene (boiling point 138°C) and cyclohexylbenzene (CHB) (boiling point 239°C) for different concentrations of 1%, 2%, 5% and 10% by volume of CHB in the original solution. The concentration of polymer in the solution was 7g/l. The films were deposited by spin coating at 1500-2000 rpm onto a substrate coated with a rubbed polyimide alignment layer. For the 2%, 5%, and 10% solution clear evidence for uniaxial alignment of the polymer film is observed a few minutes after spin coating without further treatment. (There is some variation of the degree of alignment across the substrate which is due to imperfect rubbing of the polyimide layer in this case.) Even in the film deposited from the 1% solution a speckle contrast is observed under crossed polarizers which is indicative of a multidomain structure, that does however not exhibit a preferred orientation of the domains. After solidification of the film further treatments such as vacuum exposure and/or annealing at moderate temperatures may be used to eliminate residual solvent in the film that might affect adversely the performance and stability of electronic devices fabricated with the aligned polymer as an active layer.

This method allows very efficient alignment of polymer films at room temperature, only a few minutes are required to align the polymer. The method for alignment is believed to involve formation of a lyotropic LC phase of the polymer in the high boiling point solvent after the quick evaporation of the low boiling point solvent.

The method is fully compatible with deposition of the polymer film by printing techniques such as inkjet printing. If droplets of polymer solution are inkjet deposited onto a substrate containing an alignment layer the polymer in the droplets acquires an aligned molecular structure during drying with alignment of chains parallel to the alignment direction.

Hereunder, another method is disclosed by which the temperature that is required to align a particular liquid crystalline polymer can be reduced below the LC transition of the nematic phase.

It is based on formation of a lamellar smectic phase at temperatures below the nematic phase.

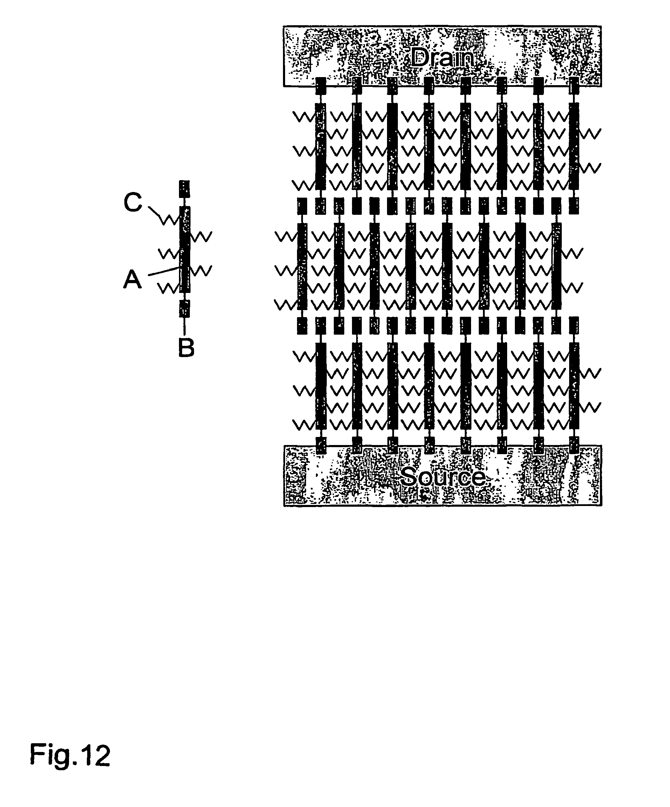

In the smectic phase the polymer forms lamellae, in which the polymer backbones extend fully across the thickness of each lamellae (figure 12). The thickness of the region between two such lamellae is defined by the polydispersity of the polymer, i.e., the higher the polydispersity the wider the boundary region. In the boundary regions between two lamellae the polymer is in a more disordered conformation. The microstructure of such smectic lamellae is similar to those of polymer single crystals (Wunderlich, Macromolecular Physics, Vol. 1, Academic Press, New York, 1973).

The smectic phase forms at lower temperatures than the corresponding nematic phase due the more favourable enthalpy, and lower entropy of the smectic phase.

The formation of such smectic lamellae can be induced by reducing the molecular weight distribution as much as possible. Only if the molecular length distribution is sufficiently narrow can lamellae with well-defined thickness be formed. The thickness of the boundary region between lamellae is the smaller the tighter the .molecular weight distribution. It is also important that the polymer backbone has a highly linear chain conformation.

The smectic organisation can also be promoted by substituting the end groups of the polymer chain with liquid crystalline small molecules such as biphenyl groups, or other phase separating groups as illustrated in figure 12 (A : polymer backbone, B : end group, C : side chain).

For any liquid crystalline polymer a combination of several of the above methods may be used to reduce the temperature of alignment of the polymer below the temperature of the bulk LC transition of the solid polymer.

All of the above techniques can be applied to the deposition of aligned polymers by inkjet printing. When inkjet printed droplets of LC polymer solution are deposited on top of an alignment layer in a TFT device configuration such as in Figure 1 or in WO01/0477045, alignment of the polymer along the direction of current transport in the device is induced during drying of the droplets.

This is achieved by any of the techniques described above. In general it is practical to use a solvent with a high boiling point, i.e. higher than typically 100°C that allows slow drying of the solvent on the substrate without need for careful control of a solvent saturated atmosphere around the printer. However, an additional requirement that must be fulfilled in the case of inkjet deposition is that the drying mode of the droplets on the substrate needs to be such that a homogeneous film thickness is obtained. In many cases, in particular if nonpolar solvents with low surface energy are used, the drying mode of the droplet is similar to that of a coffee-stain, i.e. during drying there is a flow of liquid from the centre of the droplet to its edge, that takes the dissolved material with it, such that deposition of material upon drying occurs only at the edges of the droplet with little material deposited in its centre. This is undesirable for many device applications, including the fabrication of the active semiconducting layer island of a TFT.

If coffee-stain drying is a problem for the particular combination of substrate/polymer solution homogeneous drying can be promoted by several techniques: The surface of the substrate can be modified by surface modifying treatment such as plasma exposure or treatment with a self assembled monolayer. On a substrate with a low surface energy the droplets tend to shrink, and dry homogeneously. The surface energy of the solution can be increased by using a solvent with higher surface energy, or adding a cosolvent with a higher surface energy or a surface modifying agent to the solution. Another technique is to expose the drying droplets to a flow of gas (WO 01/70506). Another useful technique is to deposit the polymer from a mixture of high and low boiling point solvents. Upon drying the low boiling point solvent evaporates quickly, and leaves behind a concentrated solution of the high boiling point solvent. If this concentrated solution has sufficiently high viscosity and flow inside the droplet is be strongly dampened, the formation of a drying ring can be suppressed and a homogeneous film thickness across the diameter of the drying droplet can be achieved.

It has been shown above that mixtures of high and low boiling point solvents also allow very efficient alignment of polymers upon drying.

This process is particularly useful for the definition of aligned active semiconducting layers of TFT devices as described in UK 0116735.2.

In WO01/047045, a method is described by which all-polymer thin film transistors can be fabricated by direct inkjet printing (Fig. 1(a)). To achieve patterning of source-drain electrodes 3 with spatial resolution of a few µm, a surface free energy pattern 2 is first fabricated on the substrate, which can then be used to confine the spreading of droplets of a conducting ink resulting in accurate channel definition. The formation of source-drain electrodes is then followed by coating of thin films of semiconducting 4 and gate insulating layers 5 and by inkjet printing deposition of the gate electrode 6.

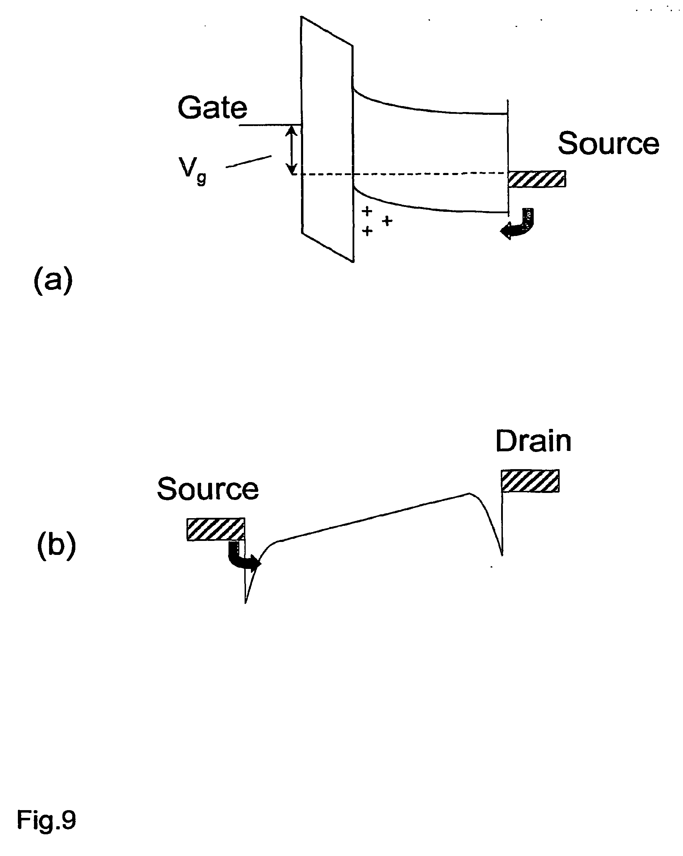

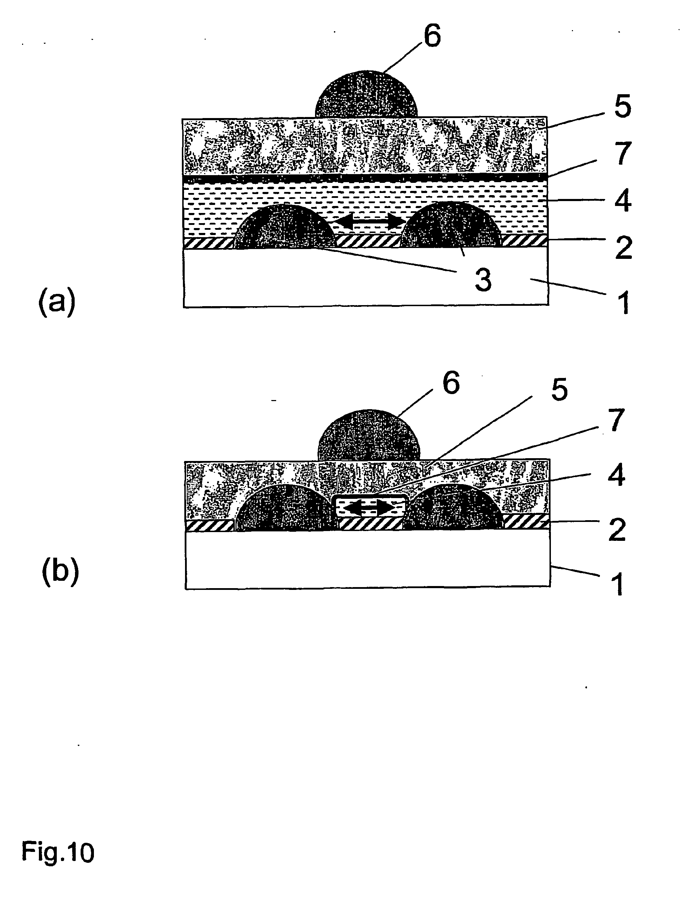

One of the disadvantages of this device configuration is that the charge injecting source-drain electrodes are not in direct contact with the thin accumulation layer 7 at the interface between the semiconductor 4 and dielectric 5. This results in a non-negligible parasitic contact resistance due to current injection across the Schottky barrier at the interface between the conducting electrode and semiconductor, as well as transport through the bulk of the intrinsic semiconducting layer (Fig. 9). The parasitic contact resistance can be significantly reduced if the semiconducting layer is only formed in the channel region of the device without covering the source-drain electrodes (Fig.10(b)). In this case the electrodes are in direct contact with the accumulation layer on the surface. The injection barrier at the interface is lowered by the applied gate field (Fig. 9(b)), and injection can occur by direct injection from the electrode into the accumulation layer without transport through the bulk of the semiconducting polymer.

The device configuration in Fig. 10(b) can be fabricated by high-resolution inkjet printing of the semiconducting polymer making use of the surface energy contrast that exists between the electrode regions and the hydrophobic material that defines the channel of the device. After deposition of the electrodes the hydrophobic surface energy region 2 (formed, for example, from polyimide) has two adjacent hydrophilic barriers (formed for example from the polar conducting polymer poly(3,4-ethylenedioxythiophene) protonated with polystyrene sulfonic acid (PEDOT/PSS)). The basic idea of the invention disclosed here is to use the different surface properties of the two surface regions to act as an ink confinement structure for the deposition of the next layer.

In many cases the surface of the electrode regions 3 will be more polar than that of the hydrophobic barrier 2. In general, it is more difficult to use a polar surface region as a repulsive surface energy barrier than a non-polar barrier. This is because of the high surface energy of most polar surfaces, which means that most inks, in particular inks formulated in non-polar solvents tend to wet the polar surface. In order to achieve a higher contact angle of the semiconducting polymer ink on the source-drain electrodes than on the surface of the hydrophobic material that defines the channel dimensions, the semiconductor ink needs to be deposited from a nonpolar solvent with a high surface energy. It is also beneficial to choose a solvent that has a high interface energy in contact with the source-drain electrode surface, i.e. the interactions between solvent molecules and the molecules on the surface of the electrode should be energetically unfavourable. In addition, the surface energy of the polar electrode surface can be decreased by adding a surface active surfactant into the conducting ink formulation that segregate to the surface by annealing of the conducting electrodes prior to the deposition of the semiconducting layer. Alternatively, the electrode surface or the hydrophobic surface 2 can be selectively modified, for example, by deposition of a self-assembled monolayer that binds selectively only to one of the two surface regions. An example of such a surface modification agent is a fluorinated self assembled monolayer such as a fluorinated chlorosilane, that requires a hydrophilic OH group to bind to a surface. Therefore, when a source-drain pattern of PEDOT-PSS separated by a hydrophobic barrier of polyimide is exposed to a solution of vapour of the fluorinated chlorosilane, only the surface of the PEDOT-PSS is fluorinated, which results in a lower surface energy of the fluorinated PEDOT-PSS surface than of the polyimide surface. The PEDOT surface then acts as a surface energy barrier for the deposition of the semiconducting polymer ink from a nonpolar solvent.

In order for the deposition of the semiconducting polymer to be confined to within the narrow strip it is important that the semiconducting ink does not wet the surface of the conducting polymer electrodes, and that the contact line of the drying droplet does not become pinned on the surface of the conducting electrode. For typical droplet volumes of state-of-the-art inkjet printers of 2-20pl and channel lengths less than 5-10 µm, the volume of the deposited droplets will be sufficiently large that they overflow into the repelling hydrophilic surface regions. However, as long as the contact line does not become pinned on the hydrophilic surface, upon drying the droplets will recede again. Surface wetting conditions can be adjusted as described above, i.e. for example by selective fluorination of the electrode surface, such that the contact line only becomes pinned when it reaches the boundary of the hydrophobic region and the hydrophilic electrode region, and a homogeneous semiconducting polymer film confined to the hydrophobic barrier region is obtained.

Under certain process conditions it is possible that some semiconducting material remains on the electrode regions. In this case injection can be improved by annealing the substrate after deposition of the semiconducting material. If the semiconducting layer is thin, and the interface energy between the polar electrode and the non-polar polymer is high, the semiconducting layer will de-wet on the electrode regions during such an anneal, and will remain continuous on top of the hydrophobic barrier layer, also resulting in more efficient charge injection.

Another advantage of this device configuration is the absence of any semiconducting layer in between neighbouring devices reducing cross talk and leakage currents between adjacent transistors.

As discussed above the techniques disclosed here allows low temperature and even room temperature alignment of rigid rod LC polymer semiconductors. This relaxes some of the requirements for the hydrophobic surface energy barrier 2 (Fig. 10) that defines the channel region and is also used as an alignment layer for the LC polymer. Such requirements are a sufficiently high glass transition temperature or generally temperature stability to provide a strong alignment torque at the temperature at which alignment of the LC polymer is induced.

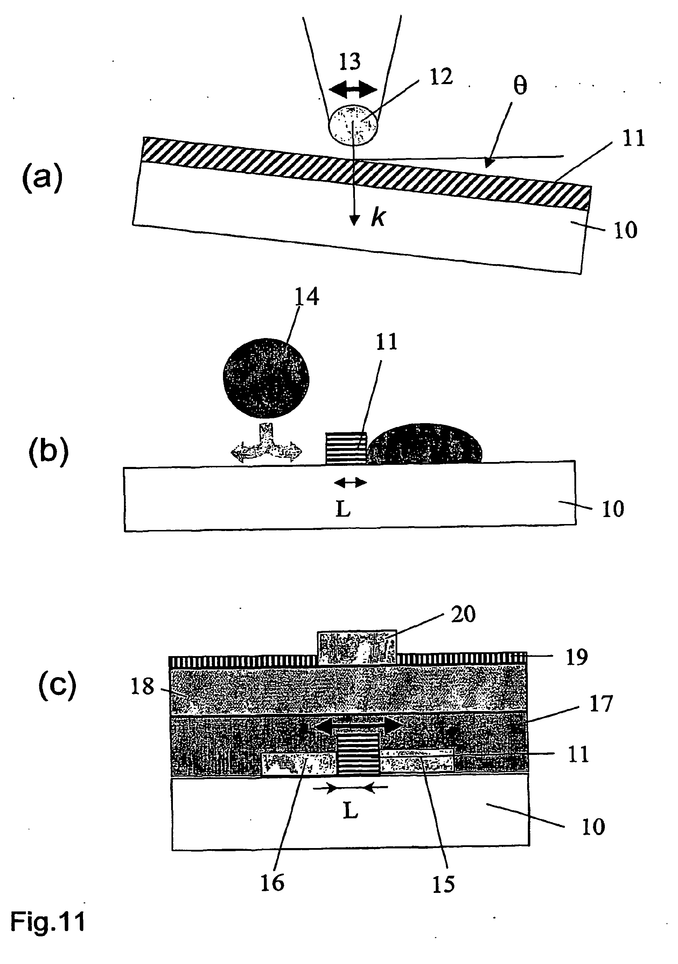

In UK 0116174.4 a specific technique for defining the surface energy barrier / alignment layer is disclosed. The technique is based on photoalignment which is less prone to mechanical damage than rubbing. A photosensitive polymer is polymerized by exposure with linearly polarized light. The plane of polarization of the light defines a preferential orientation of the chains of the photosensitive polymer. Such layers can be used as alignment layers for a broad range of polymer and small molecule liquid crystals (M. Schadt, et al., Nature 381, 212 (1996)). In photoalignable polymers the tilt angle of the LC polymer can be controlled over a wide range. It is defined by the plane of polarization and the angle of incidence of the incoming light beam with respect to the surface normal (figure 11).

With this approach the layer can be patterned and photoaligned in the same step. The photoalignment process is essentially a light-induced photopolymerisation, in which the direction of polarisation of the incident light defines the preferred direction of the polymer backbone. The wavelength of light is typically in the ultraviolet range. In the regions were the photopolymer is exposed to the light beam it become insoluble or at least less soluble than in the unexposed regions.

The pattern can therefore be developed by a subsequent washing step in the solvent that had been used for the deposition of the monomeric solution or some other suitable solvent. The pattern can be defined by exposing the substrate through a photomask or by exposing it to an array of finely focussed beams that can be scanned on the substrate.

The low temperature alignment technique disclosed in this invention allows to use a broad range of photoalignable polymers, such as the Staralign photopolymer series from Vantico (www.vantico.com).

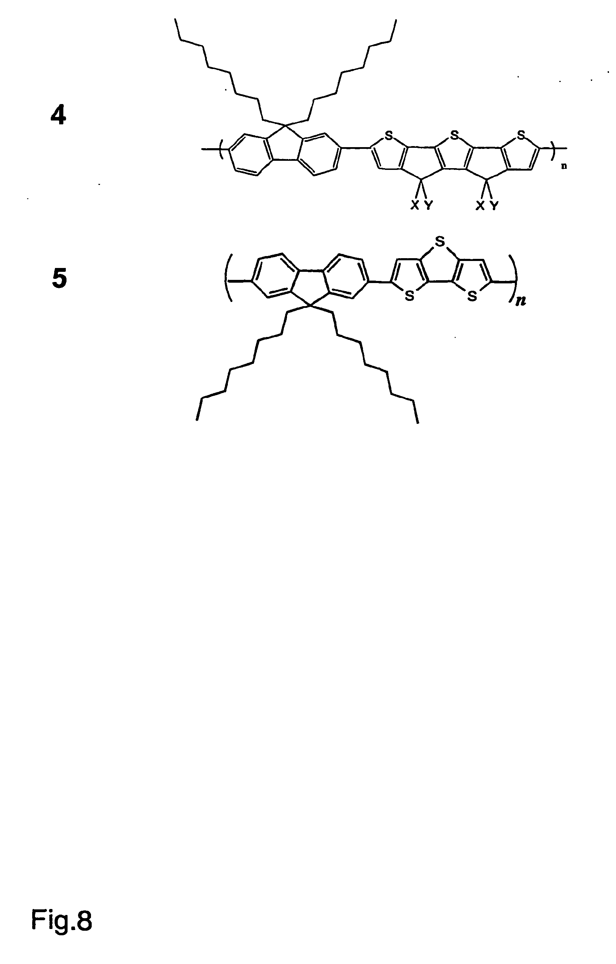

The methods described above may generally be applied to a range of conjugated rigid-rod homopolymers or block copolymers such as fluorene derivatives (US 5,777,070), indenofluorene derivatives (S. Setayesh, Macromolecules 33, 2016 (2000)), phenylene or ladder-type phenylene derivatives (J. Grimme et al., Adv. Mat. 7,292 (1995)) (figures 7 and 8).

Hereunder, several materials design criteria and materials according to such criteria are disclosed for new rigid rod polymer semiconductors for TFT applications that yield improved field-effect mobilities.

One of the general issues with using rigid-rod LC polymers in TFT devices is the compromise between the need for low processing and alignment temperatures and the need for strong interchain interactions in order to achieve efficient interchain transport. Although it is possible to align polymers with pronounced interchain interactions according to the methods described above, in many cases processibility is achieved by encapsulating the polymer backbone with flexible side chains that tend to weaken interchain interactions. Attractive interchain interactions tend to stabilize the crystalline phase with respect to a liquid crystalline melt, and therefore increase the alignment temperatures.

Here we disclose a method by which high charge carrier mobilities can be achieved in aligned polymer systems in which interchain interactions are weak. The method is based on bringing the polymer into a smectic lamella phase with orientation of the lamellae perpendicular to the direction of charge transport from source to drain. It is required that the molecular weight distribution of the polymer is narrow in order to form boundary regions between adjacent lamellae that are as thin as possible. Therefore, the polydispersity of the polymer should be as low as possible, preferably below 2.5, most preferably below 1.5.

Charge carrier transport along the direction of polymer alignment in a smectic conjugated polymer is believed to proceed as follows. In each smectic lamella the carriers travel fast along the aligned backbone, and the charge transport becomes limited by the transport in the more disordered boundary regions between the lamellae. A technique to increase the mobility in this regime is to reduce the polydispersity as much as possible in order to reduce the size of the boundary regions between the smectic lamella, and to increase the molecular weight of the polymer. An optimum molecular weight exists beyond which the degree of entanglement in the polymer become so large that the thickness of the smectic lamellae does no longer scale with the molecular weight. Instead hairpin defects and other folding defects are introduced which result in back folding of the chains into the lamella in the boundary region.

The low polydispersity that is required for the formation of the lamella structure can be achieved by synthesizing the polymer by polymerisation methods that are capable of small polydispersities or by fractionating a broader distribution of molecular weights, for example by chromatographic techniques.

In the disordered boundary regions between individual smectic lamellae transport is limited by interchain hopping between neighbouring chains. Since in the boundary regions the density of chain ends is very high, the interchain transport can be promoted by incorporating very efficient charge transporting groups (group B in figure 12) at the chain ends. In contrast to the polymer backbone these endgroups do not need to be substituted with solubilizing side chains, since the effect of end groups on the processibility and solubility of a long chain polymer is negligible.

The end groups should be designed such that they do not constitute an energetic barrier or a trap for carriers that are travelling along the polymer backbone, i.e. the energetic levels of the end groups should be well aligned with the charge transporting states along the polymer backbone. Examples of suitable end groups for polyfluorene polymer such as F8T2 are oligothiophene end groups such as bithiophene or terthiophene, that can closely π-stack with end groups of chains from the neighbouring lamellae allowing efficient interchain transport from the chains of one lamella to chains of the next lamella. Another suitable end group are triphenylamine end groups.

The size of the end group should be chosen such that there is efficient space filling in the boundary regions without disrupting the packing of polymer backbones in the smectic lamellae. In order to enhance the volume fraction of end groups in the boundary region dendrimeric end groups with conjugated elements in the branches of the dendrimer may also be used.

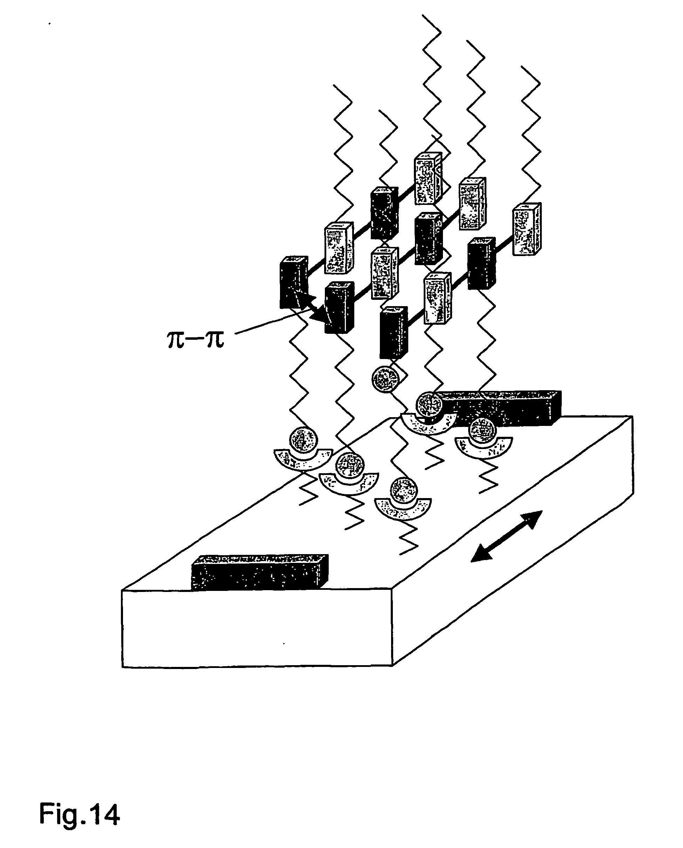

One of the benefits of the low temperature alignment techniques for rigid rod polymers for TFT devices disclosed in the this invention is the ability to process and align rigid-rod polymers in which strong interchain interactions in the solid state prevent the formation of a thermotropic phase. Polymers with strong π-π interchain interactions in the solid state tend to have very high melting temperatures and generally only exhibit liquid crystalline phases close to their decomposition temperatures. It is therefore difficult to uniaxially align such polymer through a LC phase. This is unfortunate because polymers with strong π-π interchain interactions are desirable in order to achieve high charge carrier mobilities in TFT devices. The interchain hopping of carriers from one chain onto another is believed to be the mobility limiting step in aligned polymer TFTs (figure 14). It occurs when carriers travelling along the polymer backbone reach a conjugation defect or chain end, as well as in the disordered regions of an aligned film that are associated with domain boundaries.

In order to achieve optimum charge carrier mobility in a TFT device the polymer chains should ideally be oriented such that the backbones are parallel to the direction of current flow in the TFT, and the direction of π-π stacking between adjacent chains is preferentially in the plane of the film. In this way charge carriers can travel fast along the polymer backbone (Fig. 5). In this orientation when a carrier reaches the end of a chain, or a conjugation defect, the π-π interactions allow efficient hopping to a neighbouring chain, from which the carrier can continue its fast transport along the polymer backbone.

In order to promote the preferential in-plane orientation of the direction of π-π stacking use can be made of self-assembled monolayer templates on top of the alignment layer that bind preferentially to functional groups of the side chains. Suitable surface templates may be monolayers of alkyl chains (formed from silylating agents such as octyltrichlorosilane or hexamethyldisilazane) to which alkyl side chains of the polymer are attracted. Other binding mechanisms are hydrogen bonds formed between electronegative atoms such as fluorine, nitrogen or oxygen on the surface and the hydrogen groups in the side chains of the polymers or vice versa (figure 14)

Alternatively, anisotropic preferential orientation of the π-π stacking direction may also be achieved by attracting the side chains of the polymer towards the drying surface of the film. Alkylated or fluorinated side chains tend to segregate towards the surface in order to form a surface with a low surface energy.

One of the techniques that can be used to process such strongly π-π interacting polymer is to induce a phase transformation of the polymer backbone from a liquid crystalline structure with a helical conformation of the polymer backbone into a crystalline structure with a planar conformation of the polymer backbone allowing efficient π-π interchain interaction.

In order to achieve polymer alignment at low temperature a helical conformation of the polymer backbone in which there is a finite torsional angle between subsequent monomer units of the polymer backbone is desirable. This gives rise to wrapping of the polymer backbone in a cylindrical shell of flexible side chains, that minimizes interchain interactions and lowers the viscosity of the polymer.

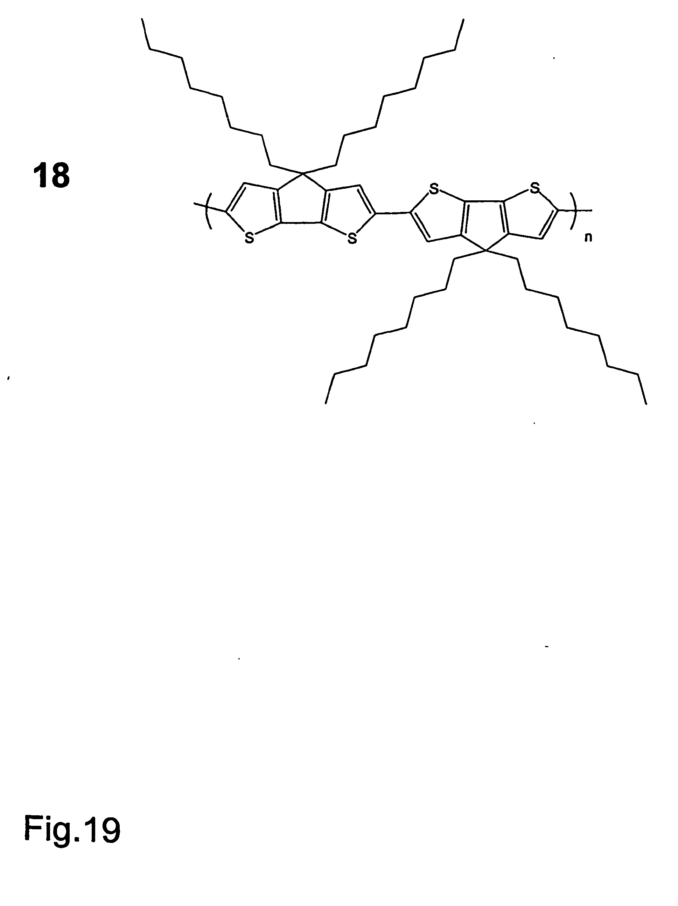

Many liquid crystalline polymers, such as dioctylfluorene (F8) or the cyclopentabithiophene-based homopolymer in figure 19 can exist in both a helical and a planar conformation. The polymer film is aligned while the chains are in a helical conformation. By annealing the film subsequently or subjecting it to mechanical stress the polymer is brought into a thermodynamically more stable planar phase. In the planar conformation interchain transport is enhanced, and it is possible to make optimum use of both efficient inter- and intrachain transport. In the planar conformation the angle between to adjacent monomers is 180°. The cyclopentabithiophene-based homopolymer is a particularly preferred embodiment because of the low ionisation potential of the polymer in comparison with F8. This allows more efficient charge injection from the source and drain electrodes of the TFT.

When the polymer is processed through a lyotropic phase, solvent molecules reduce the strength of the interchain interaction. In this way strongly interacting polymers can be aligned directly at low temperatures. Here we disclose conjugated polymer materials compositions with strong π-π interchain interactions that give useful mobilities in aligned TFT devices.

In all of the materials compositions disclosed in this invention R is a solubilising flexible side chain. Examples of suitable solubilising side chains R are hydrogen, alkyl (CₙH₂ₙ₊₁), alkoxy (OCₙH₂ₙ₊₁), or fluorinated alkyl side chains (CₙH₂ₙ₊₁ CₘF₂ₘ). The second aryl (Ar) block of the copolymers can be chosen from a large range of aromatic and heteroaromatic hole transporting or electron transporting blocks (see for example, US 5,777,070) including thiophene, dioxythiophene, triarylamine, dithienothiophene etc.

In polymers such as F8T2 close π-π interchain stacking is prevented by the side chains on the F8 unit that are emerging normally to the conjugated plane due to the sp³ coordination of the bridging carbon atom. More efficient interchain interactions and higher mobilities could be obtained if the side chains were attached in such a way that they lie preferentially in the conjugated plane of the polymer backbone.

In Figures 15 to 18 several homo- and block-copolymers are disclosed with enhanced degree of interchain interaction. In all of the polymers it is preferred that if the conjugated copolymer unit Ar has solubilising side chains, the side chains are attached such that they are in the plane of the conjugated Ar unit (see for example compound 18).

Another family of π-π interacting polymers are carbazole based homo- and block copolymers (compounds 9, 10, figure 15). In carbazole the sp³ coordinated carbon at the 9-position of the fluorene unit is replaced with a threefold coordinated nitrogen atom. The conformation of the nitrogen atom is not strictly planar, but the incorporation into the ring system exerts a planarizing effect. This rigid-rod polymer can be formed as a homopolymer or as an ordered block copolymer, preferably with a second hole-transporting block such as bithiophene or terthiophene. An additional attractive feature of the nitrogen substituent is that it gives rise to a decrease of the ionisation potential of the polymer compared to the corresponding fluorene analogue. This facilitates hole injection into the polymer from the electrodes and reduces the susceptibility of the polymer to trapping of hole carriers.

In compound 11 in-plane conformation of the side chains on the fluorine unit is achieved by attaching the side chains to an sp² coordinated carbon atom at the 9-position of the fluorene unit.

In compounds 12-16 the fluorene unit is not functionalised with flexible side chains at the central 9 position but either at the 1 and 8 positions (compound 12,13,14, 16), or the 4 and 5 positions (compound 15) (P. Skabara, J. Chem. Soc., Perkin Trans.2, 505 (1999)). In the latter configuration some steric hindrance is respected between the side chains of the fluorene unit and the aryl group. In compound 17 one of the alkyl side chains on the fluorene unit is replaced by hydrogen, allowing closer interchain packing of the chains. Note that the side chains attached to the 3-position of the thiophene rings are preferentially oriented in the conjugated plane.

One of the important design criteria for active semiconducting materials for TFT applications is the position of the ionisation potential or electron affinity that determines whether efficient charge carrier injection from the source-drain contacts is possible. For hole transporting TFTs the ionisation potential of the polymer should be in the range of 4.9-5.3 eV in order to achieve good stability against charge trapping by impurities and easy charge carrier injection from common electrodes such as gold, silver or PEDOT/PSS as well as good stability against charge transfer doping by atmospheric oxygen and other impurities. For some applications such as complementary logic circuits electron conducting polymers are required. Electron conduction requires that the electron affinity of the polymer is sufficiently high, i.e. > 3.5-4.5 eV, in order to prevent electron trapping by electronegative impurities such as oxygen.

Many p-type fluorene based homo- and block copolymers exhibit ionisation potentials higher than 5.3 eV due to the high ionisation potential of the fluorine block. The homopolymer F8 has an ionisation potential of 5.8eV, which makes hole injection from common source-drain electrode materials very difficult.

In the case of fluorene block copolymers the second block can be used to tune the ionisation potential and electron affinity of the polymer. In the case of the ladder type terthiophene block (for example, R1=R2=H) (compound 4, Roncali, et al., Adv. Mat. 6, 846 (1994)) the reduction is due to the planarisation of the thiophene ring system. In the case of dioxythiophene 7 and isothianaphtalene 6 blocks (figure 8) the reduction is due to a lowering of the band gap due to stabilisation of the quinoid form with respect to the aromatic form. Other low band gap units can be used as well (see, for example, M. Pomerantz, in Handbook of Conducting Polymers, ed. T.A. Skotheim, R.L. Elsenbaumer, J.R. Reynolds, Marcel Dekker, Inc. New York, 1998).

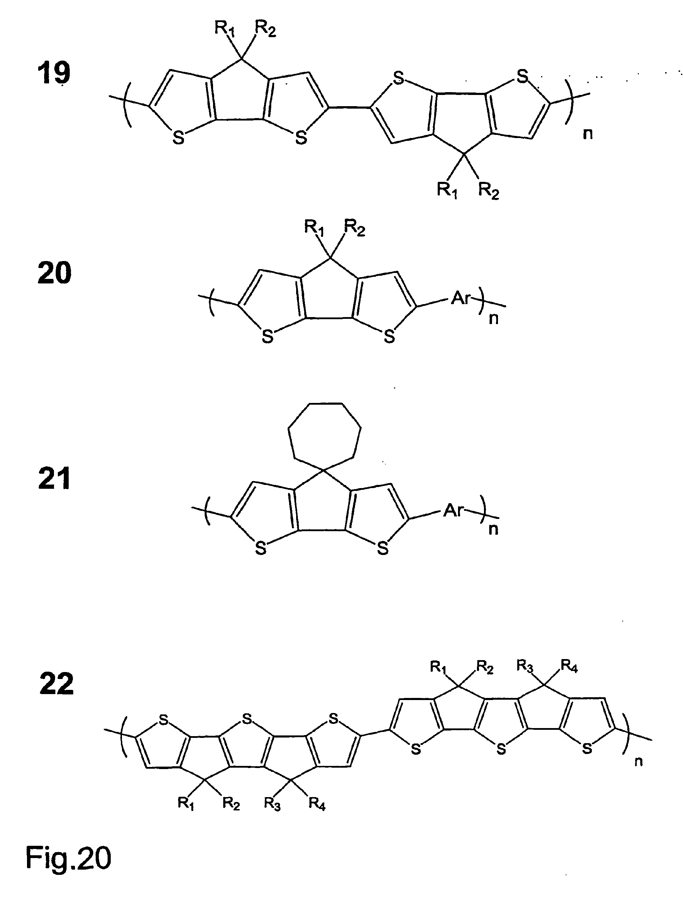

A particularly interesting new class of polymers for TFT applications are homo- and block copolymers based on cyclopentabithiophene (figures 19 and 20, compounds 18-21) or polymers based on rigidified terthiophenes (compound 22) which have lower ionisation potential than the corresponding fluorene based polymers, while maintaining the rigidity of the polymer backbone. More planar versions of cyclopentabithiophene-based polymers can also be used (compounds 23 and 24).

Monomers required for the synthesis of these polymers have been demonstrated in the literature (Benincori, et al., Chem. Mater. 13, 1665 (2001); Benincori et al., J. Chem. Soc., Chem. Communications. 891 (1996); Benincori, et al., Angew. Chem., Int. Ed. Engl. 6, 35 (1996); Sannicolo et al., Chem. Mater. 10, 2167 (1998).

Synthesis of homopolymers of these materials was previously achieved by electropolymerization. However, this technique does not yield the necessary electronic purity for thin film transistor applications. In order to ensure the necessary chemical purity and structural perfection (low polydispersity, high molecular weight, good chain linearity without branching) that is required for applications in transistor devices polymerisation needs to be performed using more controlled routes such as Suzuki coupling (US 5,777,070) or Yamamoto coupling.

Suzuki coupling also provides a way for synthesizing a range of ordered copolymers based on cyclopentadithiophene. The second block can be used to fine tune the ionisation potential of the polymer. The homopolymer cyclopentadithiophene has a low ionisation potential which makes it prone to oxidative doping by oxygen and other impurities. The ionisation potential can be increased by copolymerising a cyclopentadithiophene based block with a phenylene ring or other blocks with higher ionisation potential

Synthetic routes to monomers and electropolymerized polymers based on rigidified terthiophenes and related dithienylethylenes are described in Roncali, Advanced Materials 6, 846 (1994); Brisset, et al., J. Chem. Soc., Chem. Commun. 1997,569.

Another new class of block copolymers for TFT applications is based on indenofluorene (S. Setayesh et al., Macromolecules 33, 2016 (2000)). The main attractive feature of indenofluorene-based polymers is the linearity of the indenofluorene unit. While the fluorene unit is bent away from the in-line catenation by an angle of ca. 23°, the symmetry of the indenofluorene unit is such that the block is linear. If coupled with a similarly symmetric second block such as a bithiophene or a quaterthiophene the resulting block copolymer exhibits better linearity, and therefore better alignment when processed through its liquid crystalline phase as described above.

However in the indenofluorene case, it is very important that the second block of the copolymer gives rise to a sufficiently low ionisation potential. Suitable hole transporting units include longer oligothiophenes such as quaterthiophene (29), dioxythiophene containing blocks or dithienothiophene (compound 30) or bisdithienothiophene units. The dithienothiophene units will favour strong coplanar π-π interchain stacking and reduced oxidation potential (X. Li, et al., J. Am. Chem. Soc. 120, 2206 (1997)). More strongly π-π interacting indenofluorene based polymers analogous to the ones described above may also be used (31).

For many circuit applications such as complementary logic circuits n-type polymers with sufficiently high electron affinities are required. It has been shown that fluorine side chain substitution of thiophene oligomers can result in sufficiently high increase of electron affinity that electron transport can be achieved (A. Fachetti, et al., Angew. Chem. Intl. Edit. 39, 4547 (2000)).

Here we disclose a family of thiophene-based fluorene block-copolymers, in which n-type conductivity is induced by substitution of the thiophene block with fluorinated side chains of the form CₙH₂ₙ₊₁ CₘF₂ₘ (n≥0, m≥1) (compound 27). Similarly direct ring substitution of hydrogen by fluorine will have a strong electron withdrawing effect (compound 26). The thiophene block is an oligothiophene kT with length k=1-8. Most preferred is k = 2-4. In addition the side chains on the fluorene block can also be fluorinated side chains of the form CₙH₂ₙ₊₁ CₘF₂ₘ.

The number m of fluorinated units of the side chains can be kept small, i.e. m=1-3, in order to keep the polymers processible in common organic solvents. The dominant electron withdrawing effect onto the conjugated ring system is exerted by the fluorinated groups that are closest to the π-system.

Fluorinated side chains can also be attached to the 9-position of the fluorene unit to increase the electron affinity (compound 28).

lnkjet printing is an ideal technique to define circuits that contain both n- and p-type devices. Such circuits require patterning with high resolution to deposit n- and p-type polymers only in the channel region of the respective devices. To fabricate a complimentary inverter device, for example, at least one p-type device and one n-type device are required in close proximity. Previously, such patterning has bee achieved by shadow mask evaporation (B.K. Crone, et al. Journal of Applied Physics, 89, 5125 (2001)). In order to achieve good charge injection into n- and p-type devices it may also be required that different source-drain electrode materials are used.

With inkjet deposition inks are formulated from both n- and p-type polymers, such that n- and p-type transistors are simply be defined by selective inkjet deposition into the well defined by the respective source-drain electrodes using the process. This allows a high integration density of devices since neighbouring devices can be defined to be either n- or p-type.

In order to induce uniaxial polymer alignment according to any of the methods described above, different alignment forces can be used, such as deposition on top of a alignment substrate, i.e. a substrate that has an aligned molecular structure and/or a topographic structures such as microgrooves that induce alignment. Alternatively, alignment can be induced by application of a magnetic field, an electric field or a mechanical stress, or by inducing flow motion of the polymer solution on top of the substrate. An overview of alignment techniques is given in J. Cognard, J. Molec. Cryst. Liq. Cryst. Suppl. Ser. 1, 1 (1982).

In all of the above methods it is preferred that the polymer chains have monodomain, uniaxial alignment over the area of the electronic device. However, performance improvements may already be obtained if the alignment occurs only locally, that is, if the polymer is in a multidomain configuration with several domains with randomly oriented directors located within the active area of the device. In each domain the polymer chains would be aligned uniaxially parallel to the director, when brought into the LC phase. To produce films in a multilayer configuration no alignment layer is needed. Due to their rigid rod structure, pronounced π-π interchain stacking, and suitable ionisation potential/electron affinity all polymers disclosed in this invention have useful charge transporting properties and can be used as semiconducting layers in TFT devices even if no use is made during the device processing of their liquid crystalline properties.

Transistors and other electronic switching devices such as diodes as fabricated by any of the methods and from materials disclosed above can, for example, be used in logic circuits, analogue circuits, or active matrix displays comprising a transistor as set out above, for example as part of voltage hold circuitry of a pixel of the display.

The present invention is not limited to the foregoing examples.

In view of the foregoing description it will be evident to a person skilled in the art that various modifications may be made within the scope of the Inventions.

## Claims

1. A method for forming an aligned polymer layer, the method comprising:
depositing a film of the polymer in a solvent;
bringing the polymer into alignment whilst some of the solvent remains present in the film; wherein bringing the polymer into alignment comprises bringing the polymer into a lyotropic phase; and
solidifying the film by removing the solvent from the film.

2. A method as claimed in claim 1, wherein the step of bringing the polymer into alignment is performed whilst the amount of solvent present in the film is greater than 0.1% by weight.

3. A method as claimed in claim 2, wherein the step of bringing the polymer into alignment is performed whilst the amount of solvent present in the film is less than 20 % by weight.

4. A method as claimed in claim 1, wherein the thickness of the film is less than 100 nm.

5. A method as claimed in any preceding claim, wherein the step of solidifying the film comprises allowing the solvent to evaporate from the film.

6. A method as claimed in claim 5, wherein the time to evaporate the solvent from the film is longer than 5 minutes. '

7. A method as claimed in any preceding claim, in which the polymer is deposited from a solution in a solvent in which the radius of gyration of the polymer is larger than the radius of gyration of the polymer in its theta solvent.

8. A method as claimed in any preceding claim, wherein the step of aligning the film comprises contacting the film with an atmosphere saturated with the solvent.

9. A method as claimed in any of the preceding claims, wherein the step of aligning the polymer comprises annealing of the film whilst some of the solvent remains present in the film.

10. A method as claimed in claim 9, wherein the temperature of annealing is less than 150°C.

11. A method as claimed in any of the preceding claims, wherein the polymer is deposited from a solution that contains a first solvent and a second solvent having a lower boiling point than the first solvent.

12. A method as claimed in claim 11 in which the boiling point of the first solvent is higher than 150°C.

13. A method as claimed in claim 11 or 12 in which the boiling point of the second solvent is less than 150°C.

14. A method as claimed in any of claims 11 to 13 in which the polymer forms a lyotropic phase in the first solvent after evaporation of the second solvent.

15. A method as claimed in any preceding claim, wherein the step of bringing the polymer into alignment comprises contacting the film with an alignment substrate having a surface relief capable of inducing alignment in the polymer.

16. A method as claimed in any preceding claim, wherein the step of bringing the polymer into alignment comprises exposing the film to linearly polarised light.

17. A method as claimed in claim 15 in which the substrate capable of inducing alignment in the polymer contains a photosensitive layer that has been photoaligned and patterned by exposure to a focussed beam of polarised light.

18. A method as claimed in any preceding claim, wherein the step of solidifying the film comprises heating the film to encourage the solvent to evaporate from the film

19. A method as claimed in any preceding claim, wherein the step of solidifying the film comprises exposing the film to a vacuum to encourage the solvent to evaporate from the film.

20. A method as claimed in any preceding claim, wherein the polymer is an electroactive polymer.

21. A method as claimed in any preceding claim, wherein the polymer is a conjugated polymer.

22. A method as claimed in any preceding claim, wherein the alignment is alignment of the main chains of the polymer with respect to an alignment vector.

23. A method as claimed in any preceding claim, wherein the film is deposited by ink-jet printing.

24. A method as claimed in claim 23, wherein droplets of the polymer solution are inkjet deposited onto an alignment substrate and the polymer acquires an aligned molecular structure upon evaporation of the or each solvent.

25. A method as claimed in any of claims 1 to 24, wherein the method is a method for forming an electronic device.

26. A method as claimed in claim 25, wherein the aligned polymer layer is an active layer of the device.

27. A method as claimed in claim 26, wherein the aligned polymer layer is a conductive or semiconductive layer of the device.

28. A method as claimed in claim 27, wherein the aligned polymer layer is capable of emitting polarised light upon application of a potential across the layer.

29. A method as claimed in claim 26 to 28, wherein the device has two or more electrodes, whereby a potential may be applied across the layer.

30. A method as claimed in Claim 29, wherein the device is an electronic switching device.

31. A method according to claim 30, wherein the electronic switching device is a field-effect transistor and the polymer has any of the formulae 9-80 , 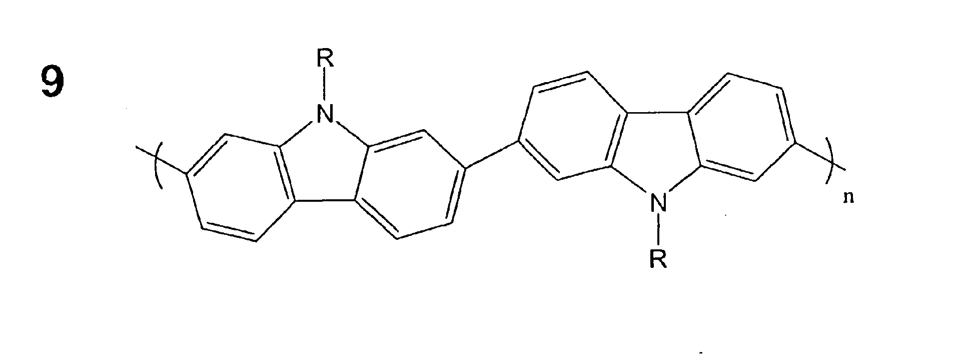 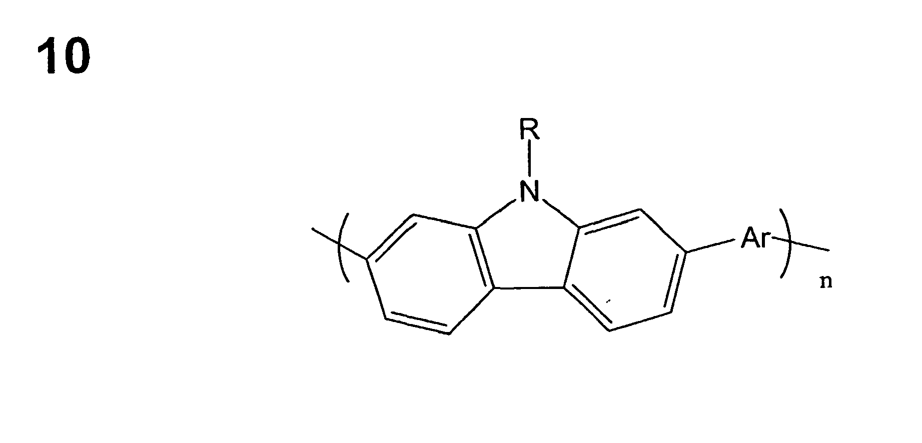 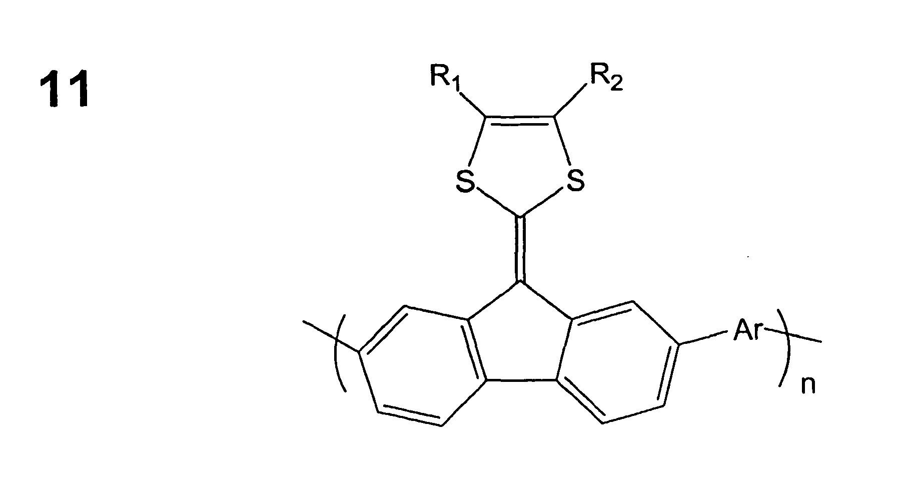 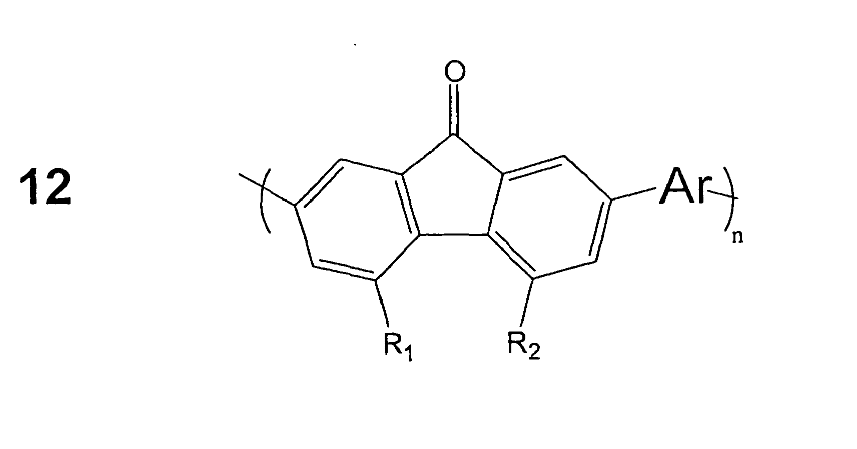 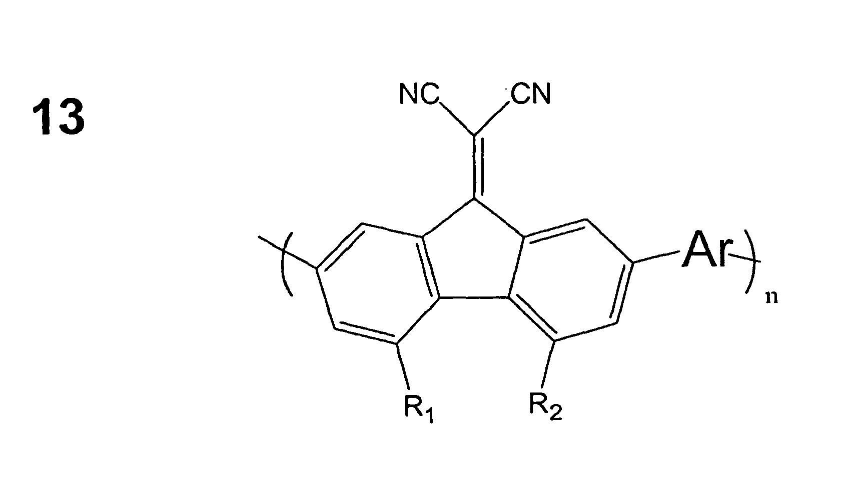 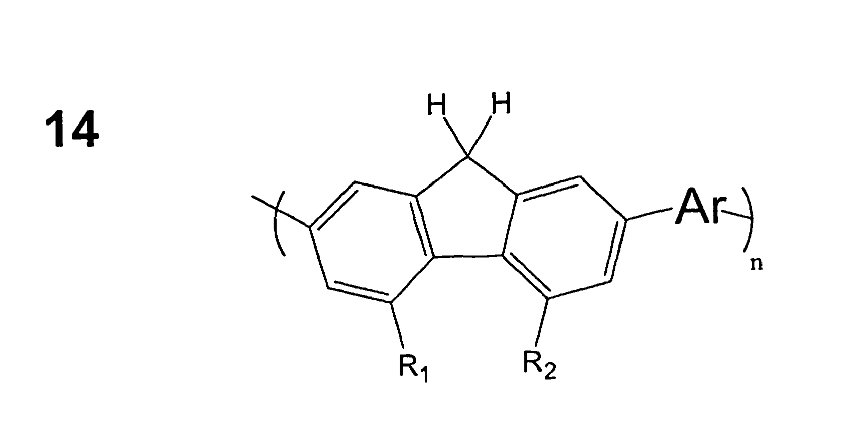 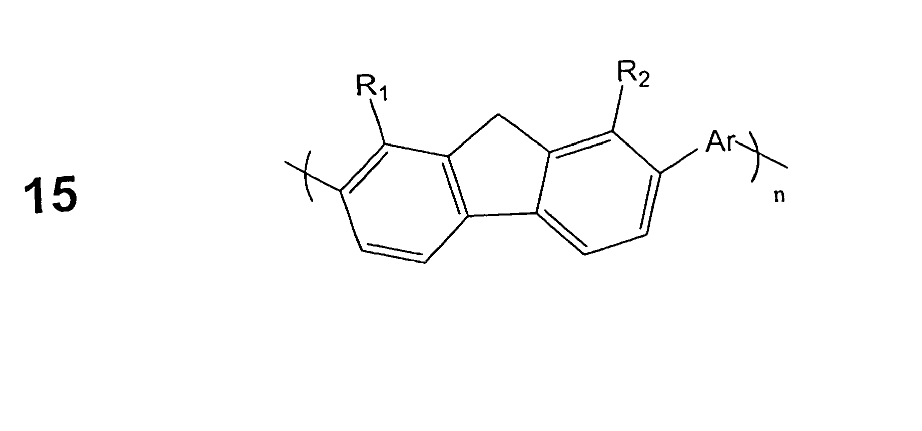 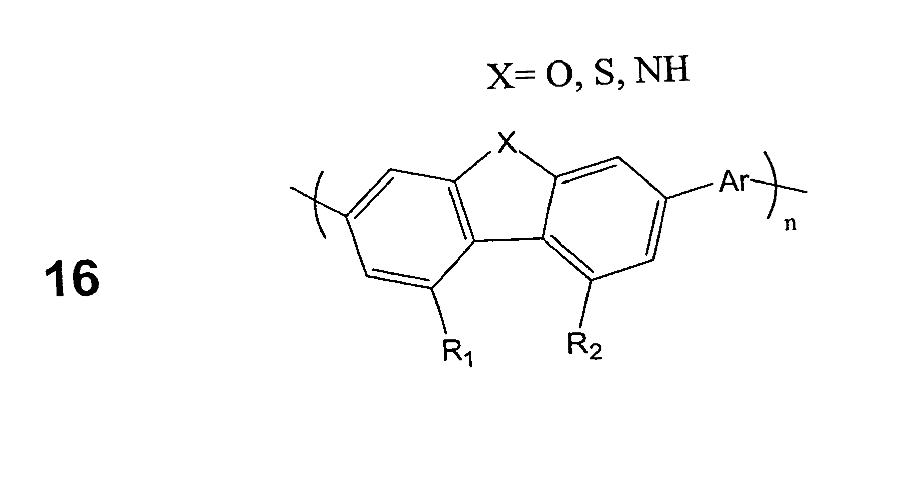 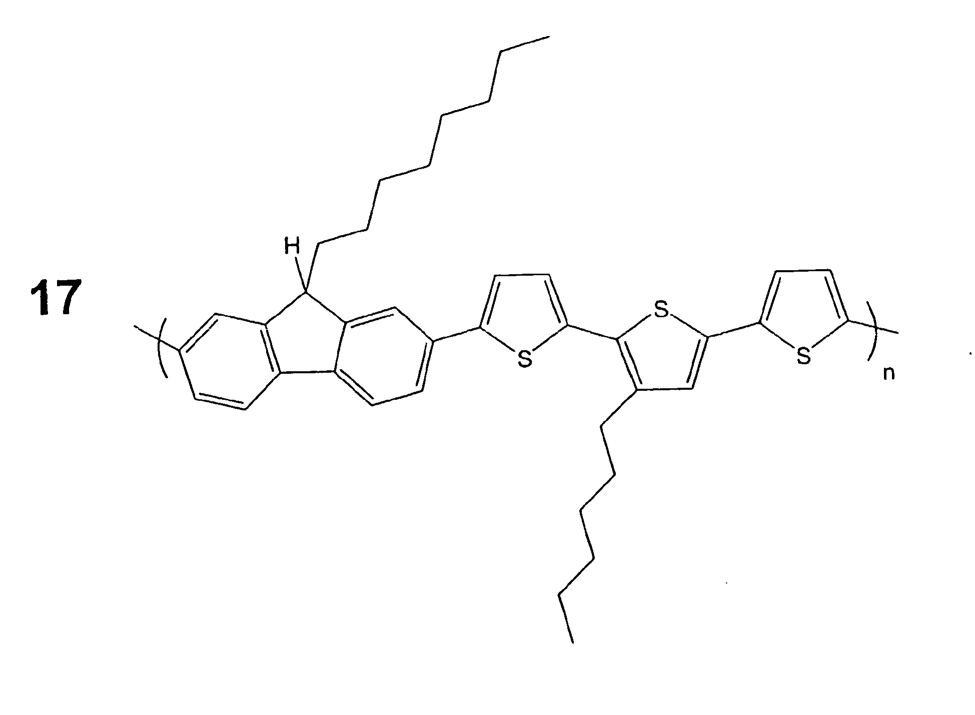 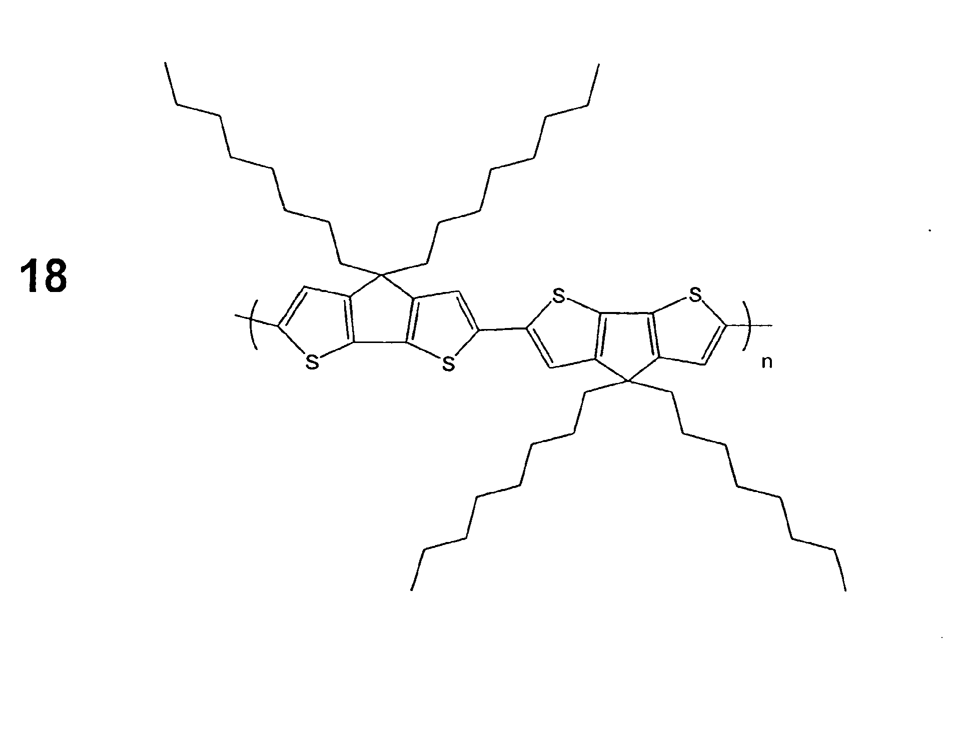 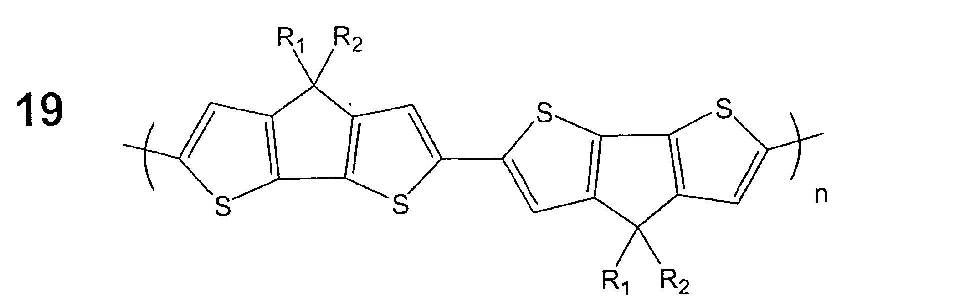 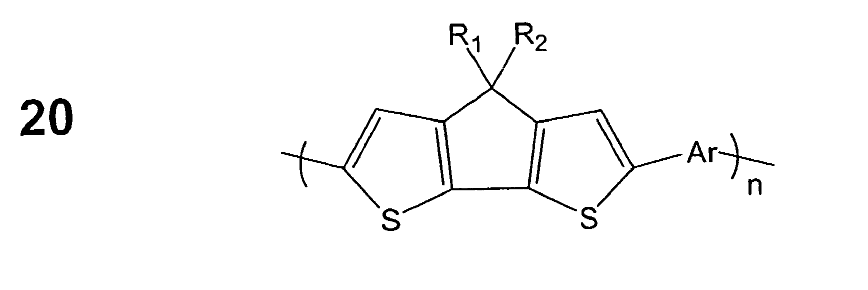 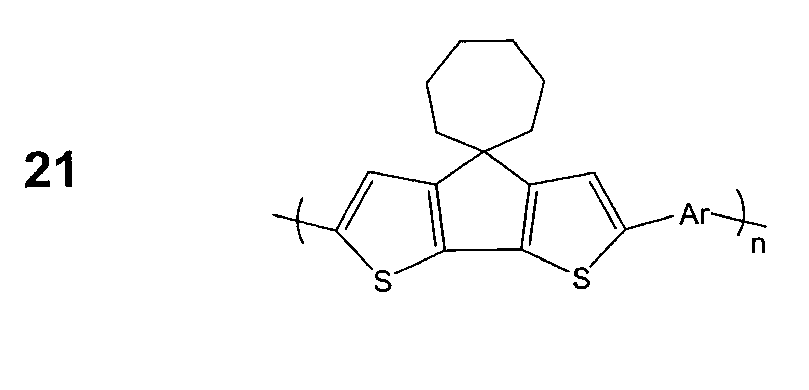 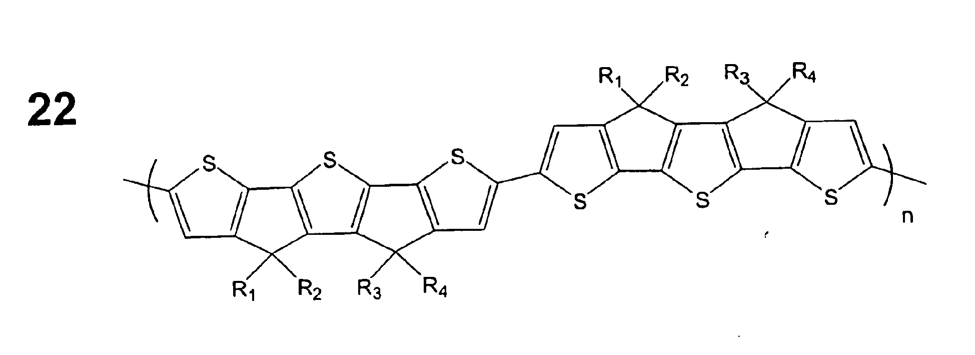 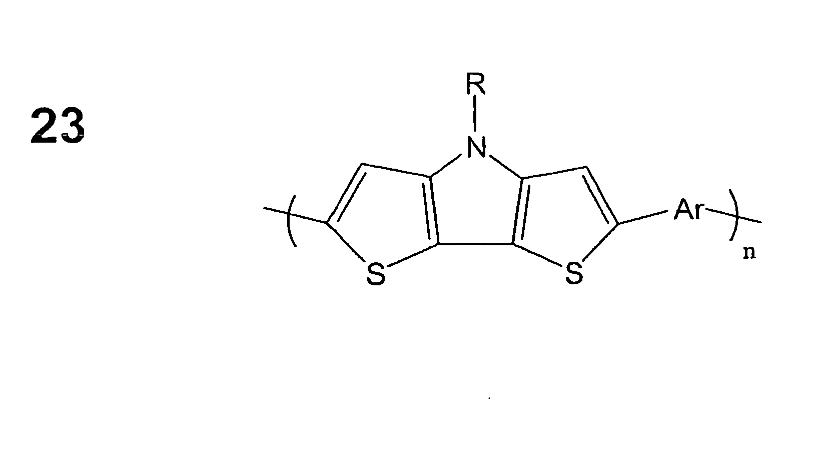 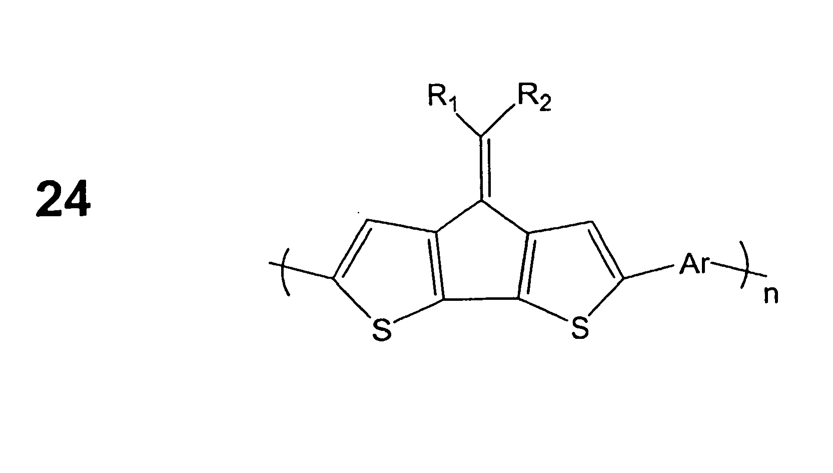 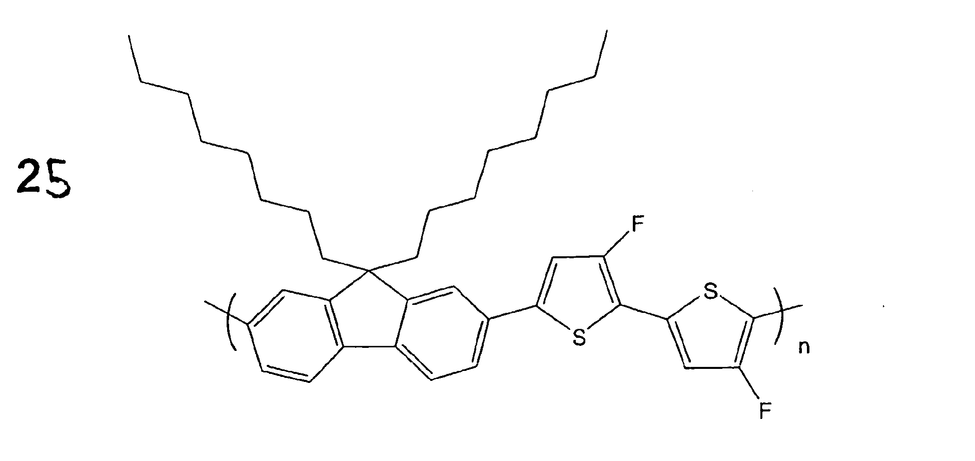 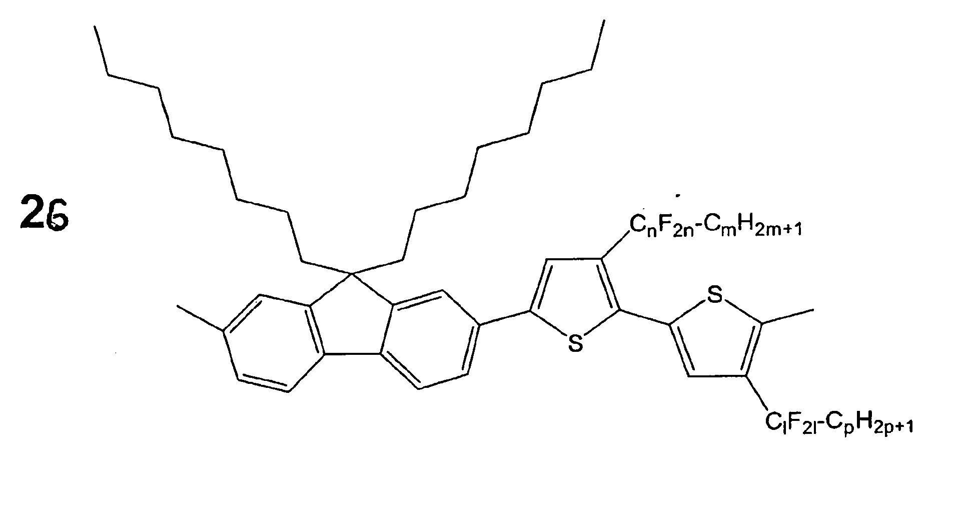 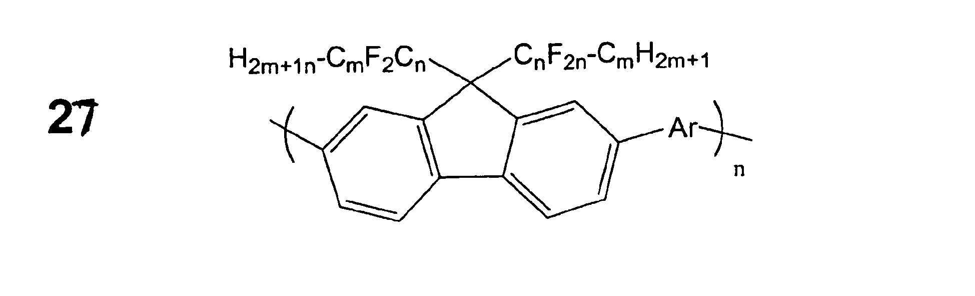 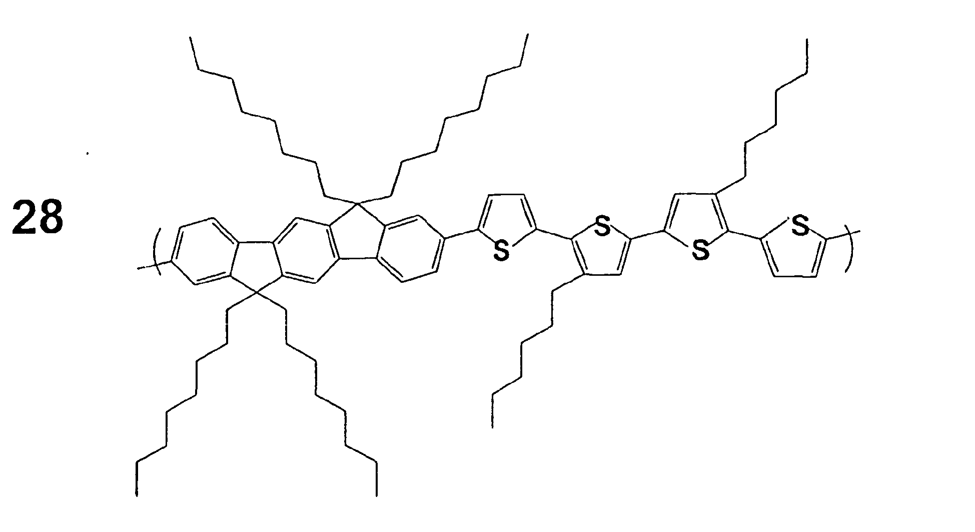 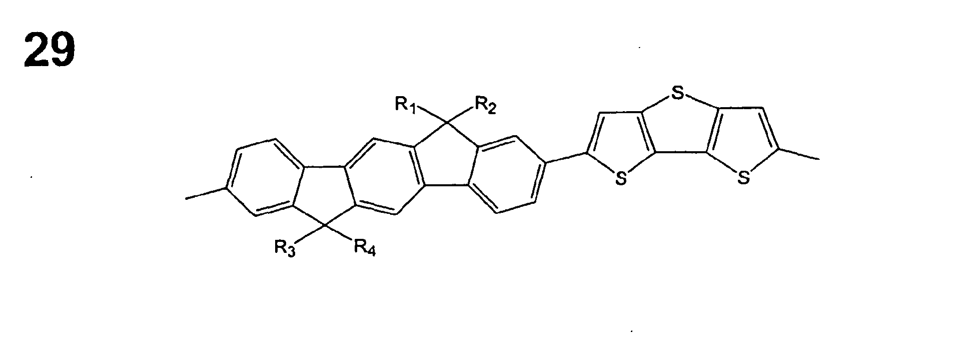 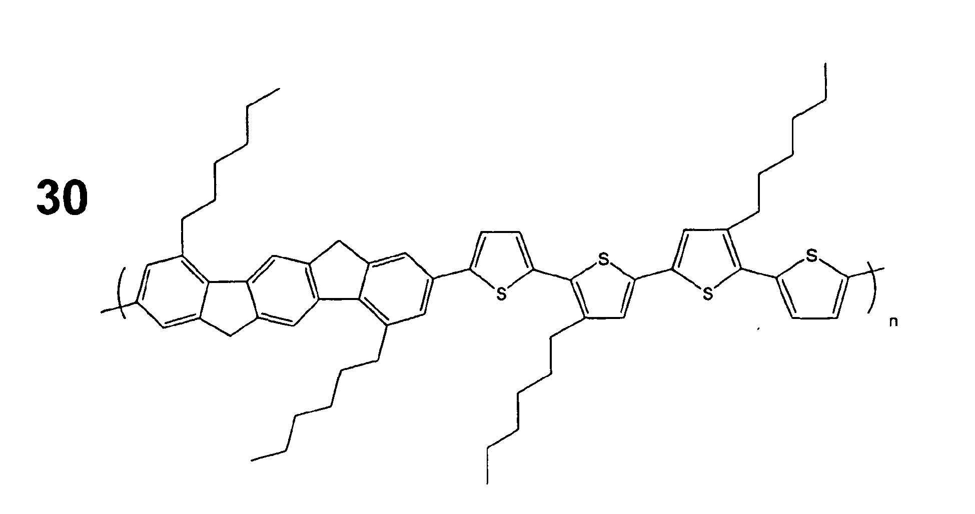 wherein:
n is an integer larger than 1; and
R, R1, R2, R3 and R4 may be the same or different in monomer unit in the polymer and are independently selected from hydrogen, alkyl groups or alkoxy groups; and
Ar is an aromatic or heteroaromatic hole transporting or electron transporting group.

32. A method as claimed in claim 31, wherein the hydrogen, alkyl or alkoxy groups are substituted with one or more fluorine atoms.

33. A method as claimed in claim 30, wherein the electronic switching, device is part of a logic circuit, display or memory device

## Patentansprüche

1. Verfahren zum Ausbilden einer ausgerichteten Polymerschicht, wobei das Verfahren umfasst:
Aufbringen eines Films des Polymers in einem Lösungsmittel;
Bringen des Polymers in Ausrichtung, während etwas des Lösungsmittels in dem Film vorhanden bleibt;
wobei Bringen des Polymers in Ausrichtung Bringen des Polymers in eine lyotropische Phase umfasst; und
Verfestigen des Films durch Entfernen des Lösungsmittels aus dem Film.

2. Verfahren nach Anspruch 1, wobei der Schritt des Bringens des Polymers in Ausrichtung durchgeführt wird, während die Menge an Lösungsmittel, welche in dem Film vorhanden ist, größer als 0,1 Gew.-% ist.

3. Verfahren nach Anspruch 2, wobei der Schritt des Bringens des Polymers in Ausrichtung durchgeführt wird, während die Menge des Lösungsmittels, welche in dem Film vorhanden ist, weniger als 20 Gew.-% ist.

4. Verfahren nach Anspruch 1, wobei die Dicke des Films weniger als 100 nm ist.

5. Verfahren nach einem der vorhergehenden Ansprüche, wobei der Schritt des Verfestigens des Filmes Verdampfen lassen des Lösungsmittels aus dem Film umfasst.

6. Verfahren nach Anspruch 5, wobei die Zeit, um das Lösungsmittel aus dem Film zu verdampfen, länger als fünf Minuten ist.

7. Verfahren nach einem der vorhergehenden Ansprüche, in welchem das Polymer aus einer Lösung in einem Lösungsmittel aufgebracht wird, in welchem der Gyrationsradius des Polymers größer ist als der Gyrationsradius des Polymers in dessen Theta-Lösungsmittel.

8. Verfahren nach einem der vorhergehenden Ansprüche, wobei der Schritt des Ausrichtens des Films in Kontakt Bringen des Films mit einer mit dem Lösungsmittel gesättigten Atmosphäre umfasst.

9. Verfahren nach einem der vorhergehenden Ansprüche, wobei der Schritt des Ausrichtens des Polymers Tempern des Films umfasst, während etwas des Lösungsmittels in dem Film vorhanden bleibt.

10. Verfahren nach Anspruch 9, wobei die Temperatur des Temperns weniger als 150 °C ist.

11. Verfahren nach einem der vorhergehenden Ansprüche, wobei das Polymer aus einer Lösung aufgebracht wird, welche ein erstes Lösungsmittel und ein zweites Lösungsmittel aufweist, das einen niedrigeren Siedepunkt aufweist als das erste Lösungsmittel.

12. Verfahren nach Anspruch 11, in welchem der Siedepunkt des ersten Lösungsmittels höher als 150 °C ist.

13. Verfahren nach Anspruch 11 oder 12, in welchem der Siedepunkt des zweiten Lösungsmittels weniger als 150 °C ist.

14. Verfahren nach einem der Ansprüche 11 bis 13, in welchem das Polymer eine lyotropische Phase in dem ersten Lösungsmittel nach Verdampfen des zweiten Lösungsmittels ausbildet.

15. Verfahren nach einem der vorhergehenden Ansprüche, wobei der Schritt des Bringens des Polymers in Ausrichtung in Kontakt Bringen des Films mit einem Ausrichtungssubstrat umfasst, welches ein Oberflächenrelief aufweist, das im Stande ist ein Ausrichten in dem Polymer zu induzieren.

16. Verfahren nach einem der vorhergehenden Ansprüche, wobei der Schritt des Bringens des Polymers in Ausrichtung Aussetzen des Films gegenüber linear polarisiertem Licht umfasst.

17. Verfahren nach Anspruch 15, in welchem das Substrat, welches im Stande ist ein Ausrichten in dem Polymer zu induzieren, eine fotoempfindliche Schicht enthält, die fotosausgerichtet und ausgestaltet durch Aussetzen gegenüber einem fokussierten Strahl von polarisiertem Licht worden ist.

18. Verfahren nach einem der vorhergehenden Ansprüche, wobei der Schritt des Verfestigens des Films Erwärmen des Films umfasst, um das Lösungsmittel zu unterstützen aus dem Film zu verdampfen.

19. Verfahren nach einem der vorhergehenden Ansprüche, wobei der Schritt des Verfestigens des Films Aussetzen des Films gegenüber einem Vakuum umfasst, um das Lösungsmittel zu unterstützen aus dem Film zu verdampfen.

20. Verfahren nach einem der vorhergehenden Ansprüche, wobei das Polymer ein elektroaktives Polymer ist.

21. Verfahren nach einem der vorhergehenden Ansprüche, wobei das Polymer ein konjugiertes Polymer ist.

22. Verfahren nach einem der vorhergehenden Ansprüche, wobei das Ausrichten ein Ausrichten der Hauptketten des Polymers in Bezug auf einen Ausrichtungsvektor ist.

23. Verfahren nach einem der vorhergehenden Ansprüche, wobei der Film durch Tintenstrahldrucken aufgebracht wird.

24. Verfahren nach Anspruch 23, wobei Tropfen der Polymerlösung durch Tintenstrahl auf einem Ausrichtungssubstrat aufgebracht werden und das Polymer eine ausgerichtete Molekularstruktur nach Verdampfen des oder jeden Lösungsmittels annimmt.

25. Verfahren nach einem der Ansprüche 1 bis 24, wobei das Verfahren ein Verfahren zum Ausbilden einer elektronischen Vorrichtung ist.

26. Verfahren nach Anspruch 25, wobei die ausgerichtete Polymerschicht eine aktive Schicht der Vorrichtung ist.

27. Verfahren nach Anspruch 26, wobei die ausgerichtete Polymerschicht eine leitende oder halbleitende Schicht der Vorrichtung ist.

28. Verfahren nach Anspruch 27, wobei die ausgerichtete Polymerschicht im Stande ist polarisiertes Licht nach Anlegen eines Potentials quer zur Schicht zu emittieren.

29. Verfahren nach einem der Ansprüche 26 bis 28, wobei die Vorrichtung zwei oder mehrere Elektroden aufweist, wodurch ein Potential quer zur Schicht angelegt werden kann.

30. Verfahren nach Anspruch 29, wobei die Vorrichtung eine elektronische Schaltvorrichtung ist.

31. Verfahren nach Anspruch 30, wobei die elektronische Schaltvorrichtung ein Feldeffekttransistor ist und das Polymer eine der Formeln 9 bis 30 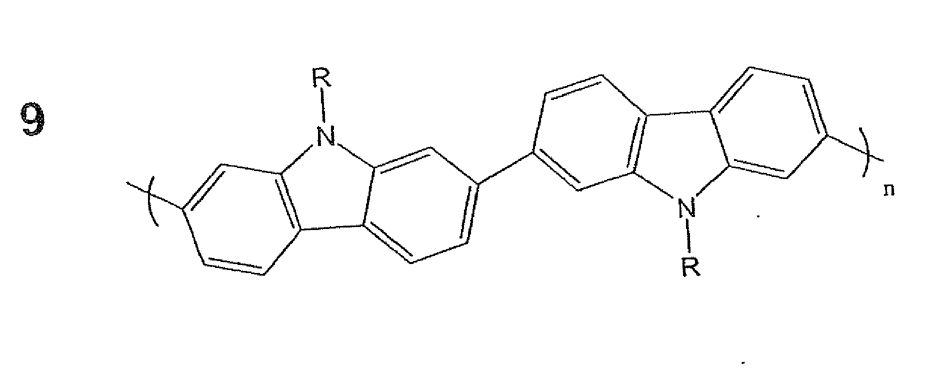 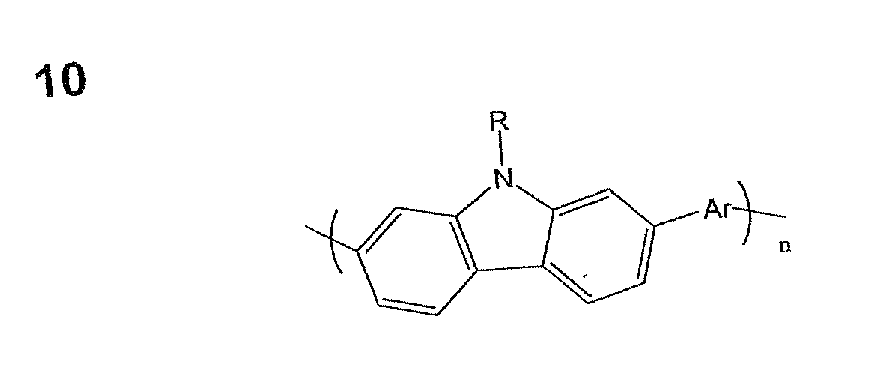 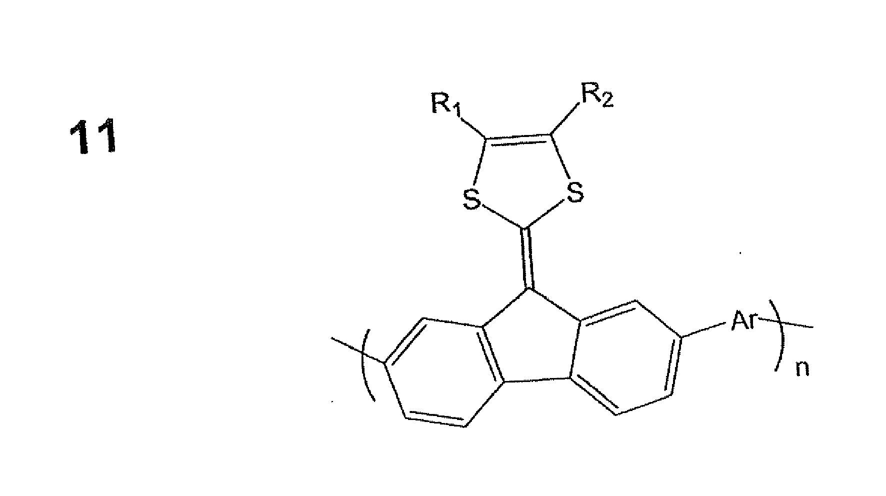 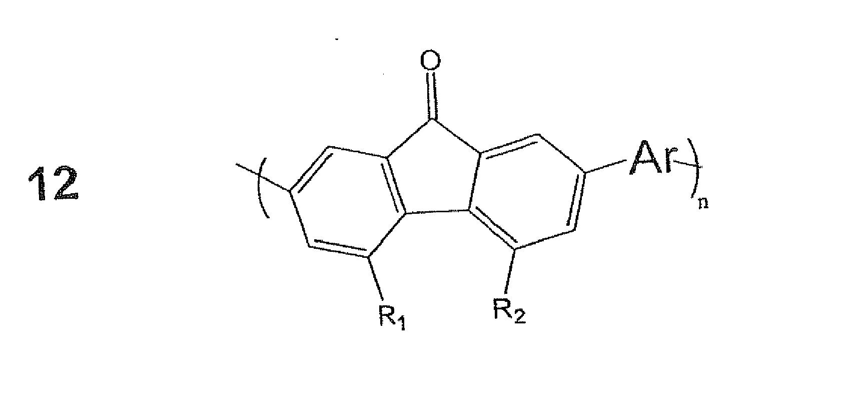 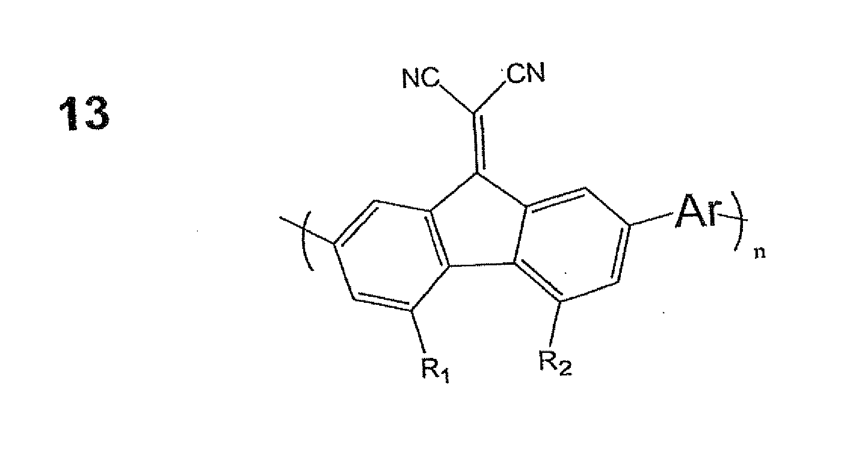 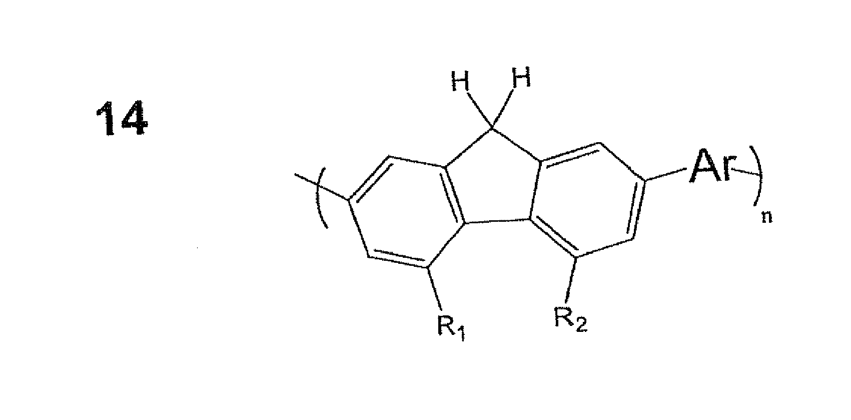 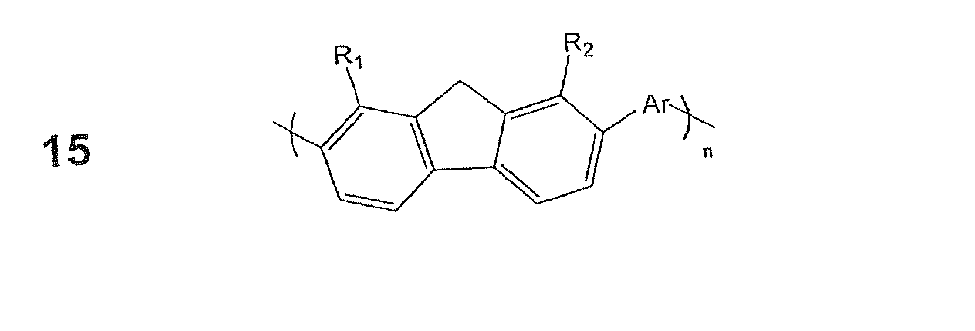 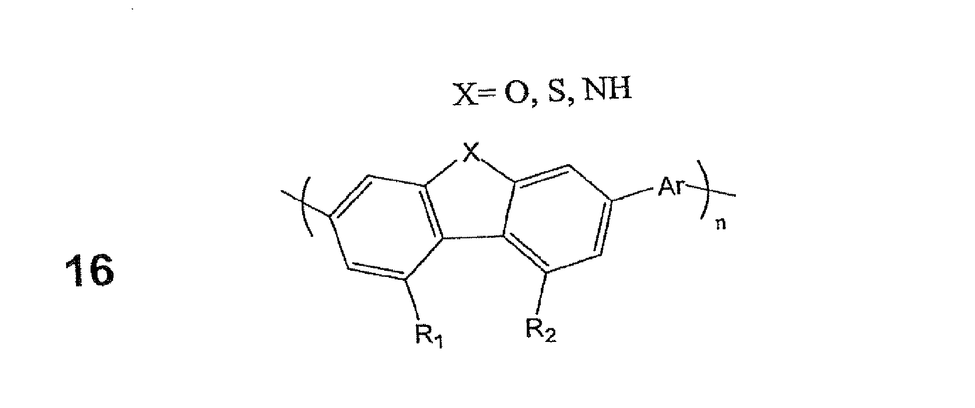 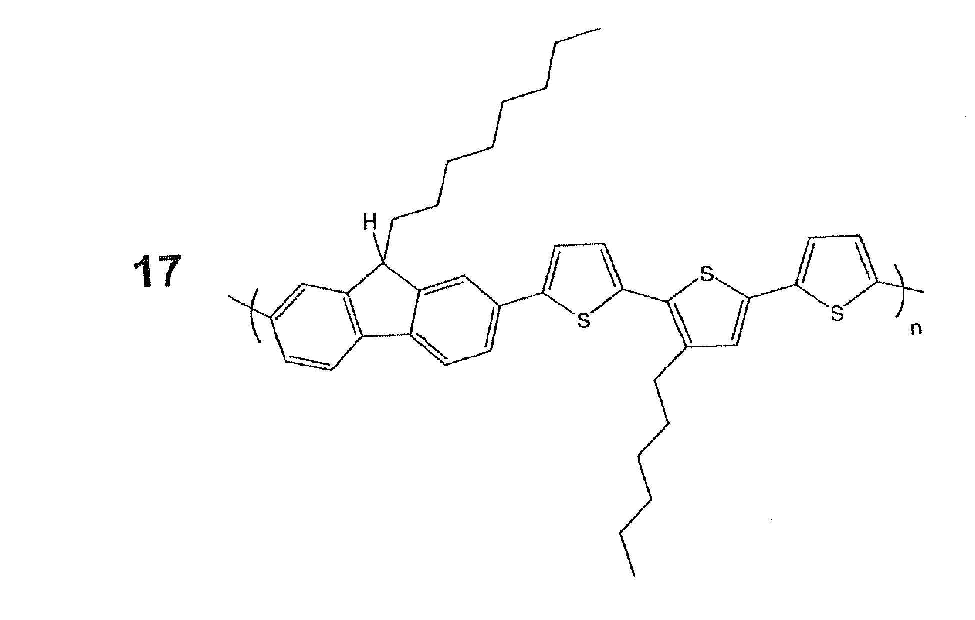 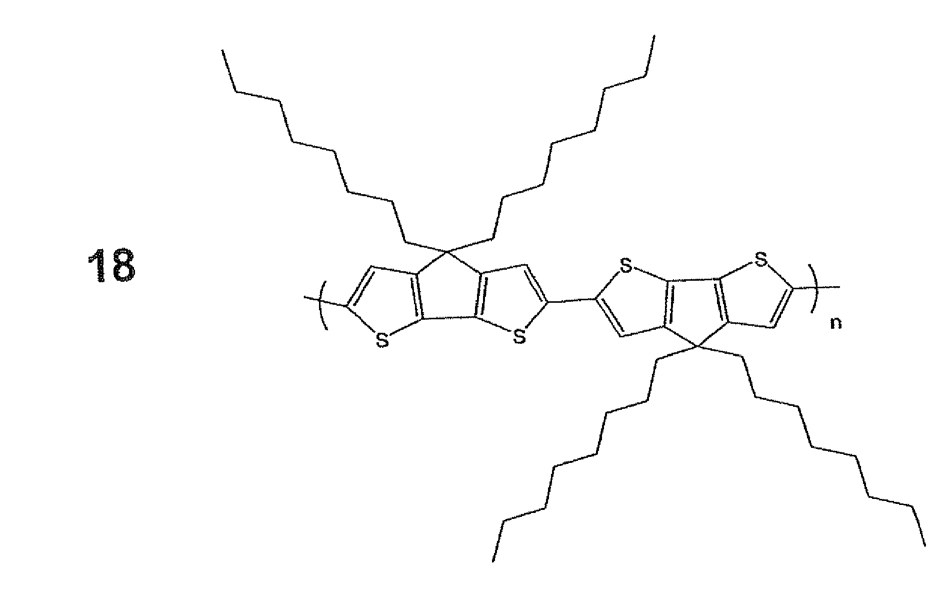 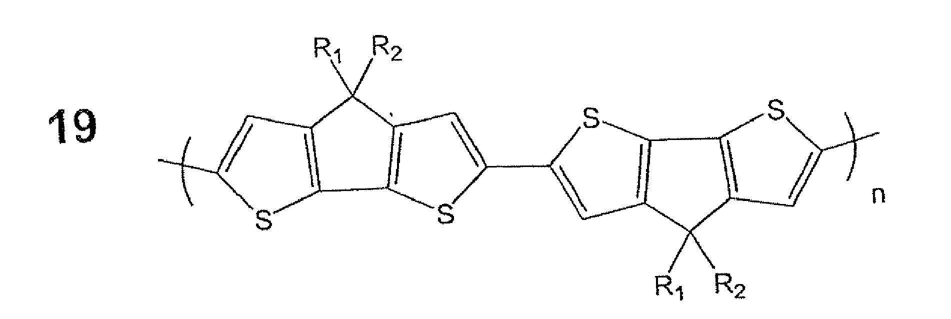 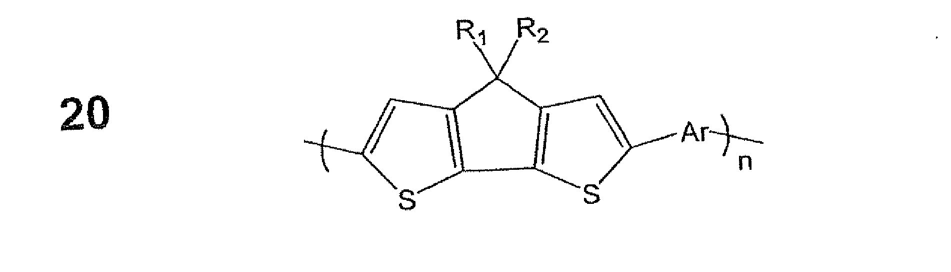 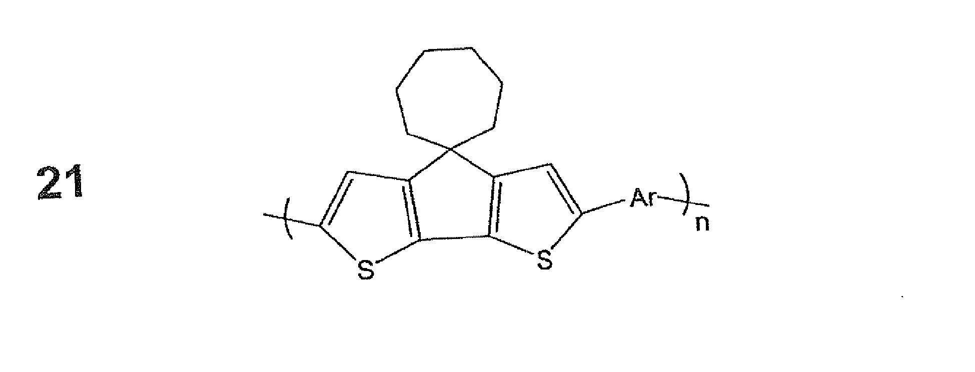 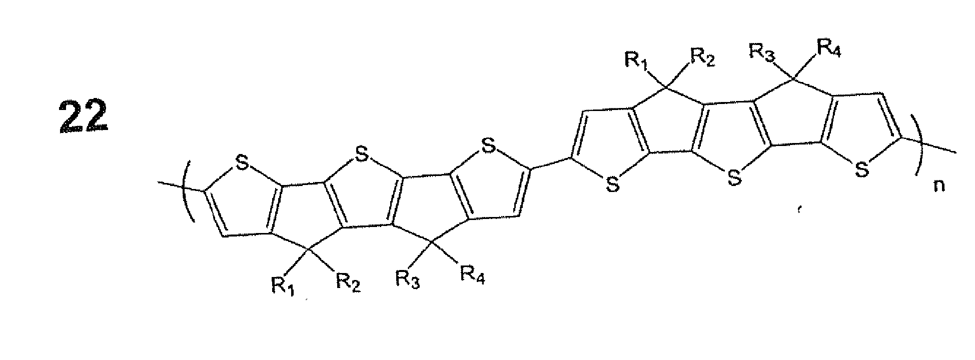 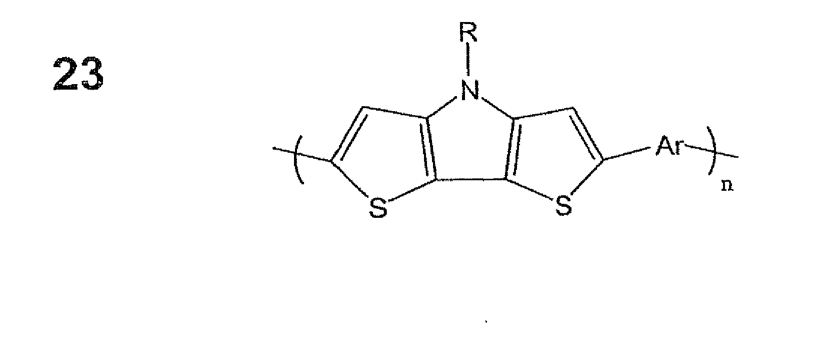 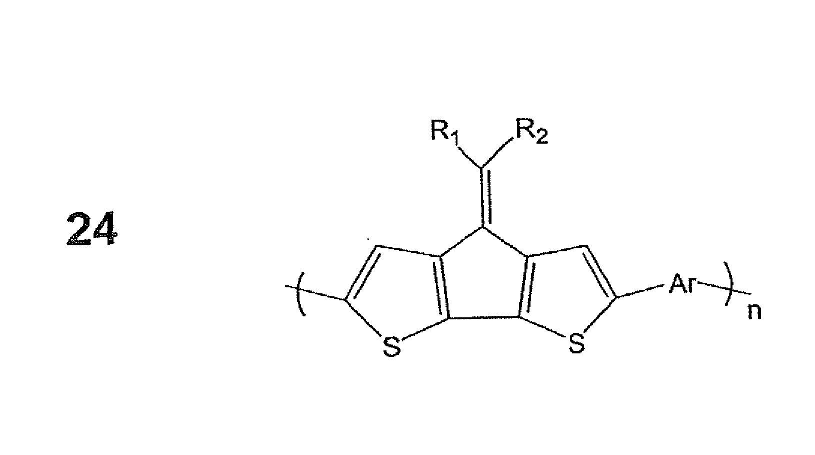 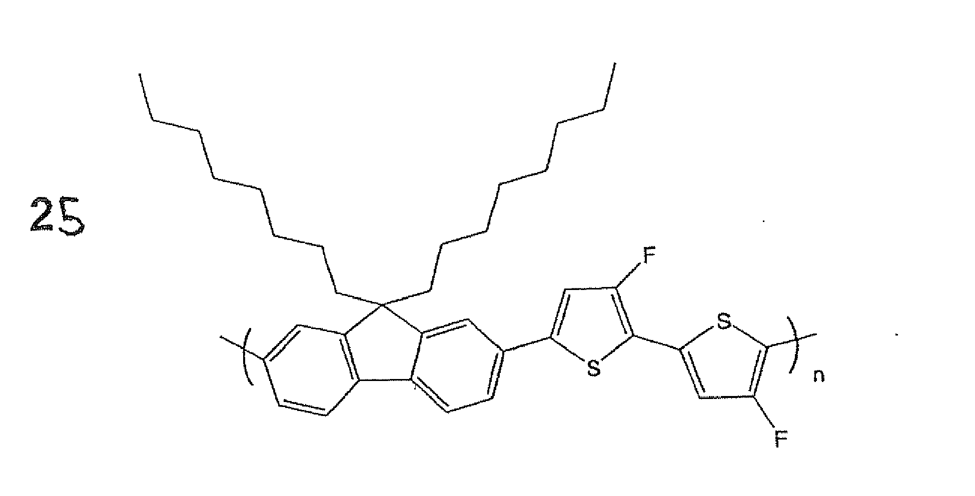 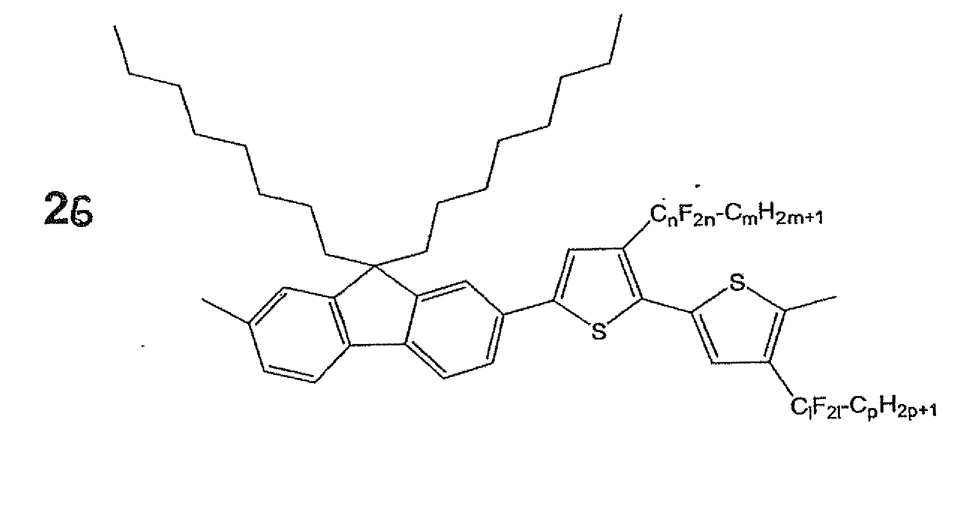 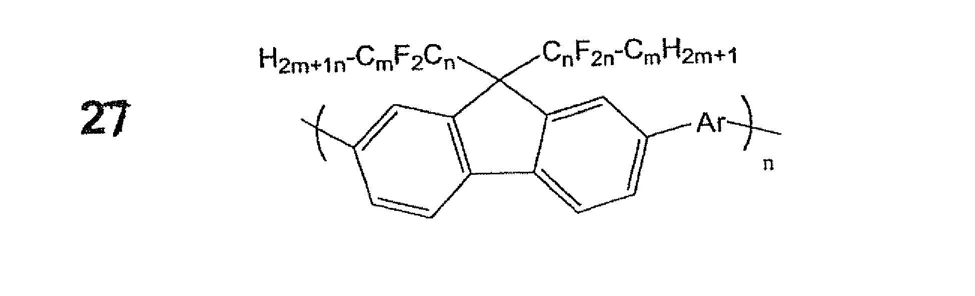 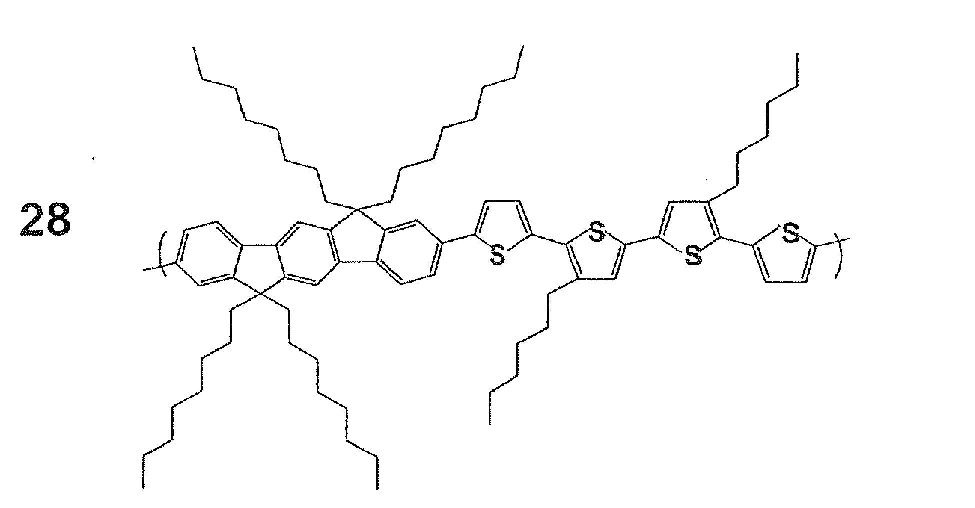 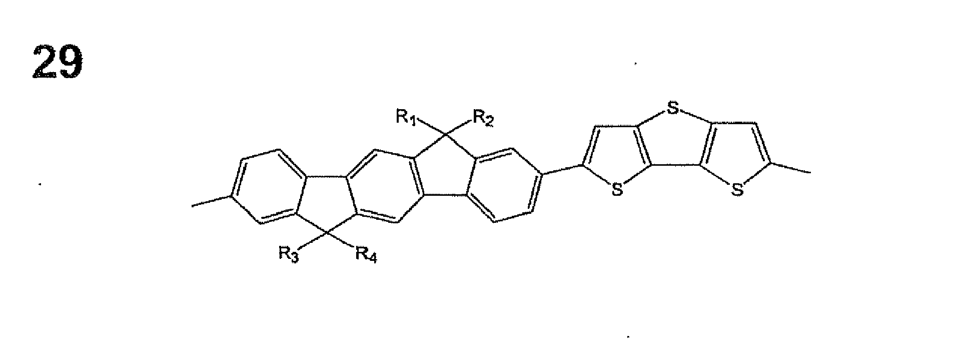 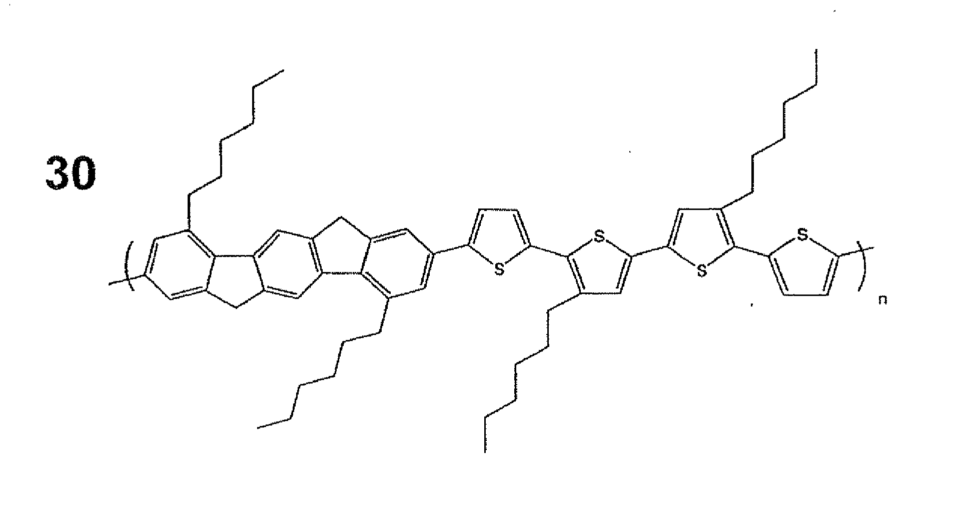 aufweist, wobei:
n eine ganze Zahl größer als 1 ist; und
R, R1, R2, R3 und R4 gleich oder unterschiedlich in jeder Monomereinheit in dem Polymer sein kann und unabhängig voneinander ausgewählt aus Wasserstoff, Alkylgruppen oder Alkoxygruppen sind; und
Ar eine aromatische oder heteroaromatische Loch transportierende oder Elektron transportierende Gruppe ist.

32. Verfahren nach Anspruch 31, wobei die Wasserstoff-, Alkyl- oder Alkoxygruppen mit einem oder mehreren Fluoratomen substituiert sind.

33. Verfahren nach Anspruch 30, wobei die elektronische Schaltvorrichtung Teil eines Logikschaltkreises, Displays oder Speichervorrichtung ist.

## Revendications

1. Procédé pour former une couche de polymère aligné, le procédé comprenant les étapes consistant :
à déposer un film du polymère dans un solvant ;
à mettre le polymère en alignement tandis qu'une partie du solvant reste présente dans le film, l'opération d'alignement du polymère comprenant l'étape consistant à mettre le polymère sous forme d'une phase lyotrope ; et
à solidifier le film en éliminant le solvant du film.

2. Procédé suivant la revendication 1, dans lequel l'étape consistant à aligner le polymère est mise en oeuvre tandis que la quantité de solvant présente dans le film est supérieure à 0,1 % en poids.

3. Procédé suivant la revendication 2, dans lequel l'étape consistant à aligner le polymère est mise en oeuvre tandis que la quantité de solvant présente dans le film est inférieure à 20 % en poids.

4. Procédé suivant la revendication 1, dans lequel l'épaisseur du film est inférieure à 100 nm.

5. Procédé suivant l'une quelconque des revendications précédentes, dans lequel l'étape de solidification du film comprend l'étape consistant à laisser le solvant s'évaporer du film.

6. Procédé suivant la revendication 5, dans lequel le temps d'évaporation du solvant du film est supérieur à 5 minutes.

7. Procédé suivant l'une quelconque des revendications précédentes, dans lequel le polymère est déposé à partir d'une solution dans un solvant où le rayon de gyration du polymère est supérieur au rayon de gyration du polymère dans son solvant thêta.

8. Procédé suivant l'une quelconque des revendications précédentes, dans lequel l'étape d'alignement du film comprend la mise en contact du film avec une atmosphère saturée du solvant.

9. Procédé suivant l'une quelconque des revendications précédentes, dans lequel l'étape d'alignement du polymère comprend le recuit du film tandis qu'une certaine quantité du solvant reste présente dans le film.

10. Procédé suivant la revendication 9, dans lequel la température de recuit est inférieure à 150°C.

11. Procédé suivant l'une quelconque des revendications précédentes, dans lequel le polymère est déposé à partir d'une solution qui contient un premier solvant et un second solvant ayant un point d'ébullition inférieur à celui du premier solvant.

12. Procédé suivant la revendication 11, dans lequel le point d'ébullition du premier solvant est supérieur à 150°C.

13. Procédé suivant la revendication 11 ou 12, dans lequel le point d'ébullition du second solvant est inférieur à 150°C.

14. Procédé suivant l'une quelconque des revendications 11 à 13, dans lequel le polymère forme une phase lyotrope dans le premier solvant après évaporation du second solvant.

15. Procédé suivant l'une quelconque des revendications précédentes, dans lequel l'étape d'alignement du polymère comprend la mise en contact du film avec un substrat d'alignement ayant un relief de surface capable d'induire un alignement dans le polymère.

16. Procédé suivant l'une quelconque des revendications précédentes, dans lequel l'étape d'alignement du polymère comprend l'exposition du film à de la lumière polarisée linéairement.

17. Procédé suivant la revendication 15, dans lequel le substrat capable d'induire un alignement dans le polymère contient une couche photosensible qui a été soumise à un photoalignement et à une formation d'un motif par exposition à un faisceau focalisé de lumière polarisée.

18. Procédé suivant l'une quelconque des revendications précédentes, dans lequel l'étape de solidification du film comprend le chauffage du film pour favoriser l'évaporation du solvant du film.

19. Procédé suivant l'une quelconque des revendications précédentes, dans lequel l'étape de solidification du film comprend l'exposition du film à un vide pour favoriser l'évaporation du solvant du film.

20. Procédé suivant l'une quelconque des revendications précédentes, dans lequel le polymère est un polymère électroactif.

21. Procédé suivant l'une quelconque des revendications précédentes, dans lequel le polymère est un polymère conjugué.

22. Procédé suivant l'une quelconque des revendications précédentes, dans lequel l'alignement est l'alignement des chaînes principales du polymère par rapport à un vecteur d'alignement.

23. Procédé suivant l'une quelconque des revendications précédentes, dans lequel le film est déposé par impression par jet d'encre.

24. Procédé suivant la revendication 23, dans lequel des gouttelettes de la solution de polymère sont déposées par jet d'encre sur un substrat d'alignement et le polymère acquière une structure moléculaire alignée par évaporation du solvant ou de chaque solvant.

25. Procédé suivant l'une quelconque des revendications 1 à 24, ledit procédé étant un procédé pour former un dispositif électronique.

26. Procédé suivant la revendication 25, dans lequel la couche de polymère aligné est une couche active du dispositif.

27. Procédé suivant la revendication 26, dans lequel la couche de polymère aligné est une couche conductrice ou semiconductrice du dispositif.

28. Procédé suivant la revendication 27, dans lequel la couche de polymère aligné est capable d'émettre de la lumière polarisée par application d'un potentiel à travers la couche.

29. Procédé suivant les revendications 26 à 28, dans lequel le dispositif comporte deux ou plus de deux électrodes, un potentiel pouvant ainsi être appliqué à travers la couche.

30. Procédé suivant la revendication 29, dans lequel le dispositif est un dispositif de commutation électronique.

31. Procédé suivant la revendication 30, dans lequel le dispositif de commutation électronique est un transistor à effet de champ et le polymère répond à n'importe laquelle des formules 9 à 30, 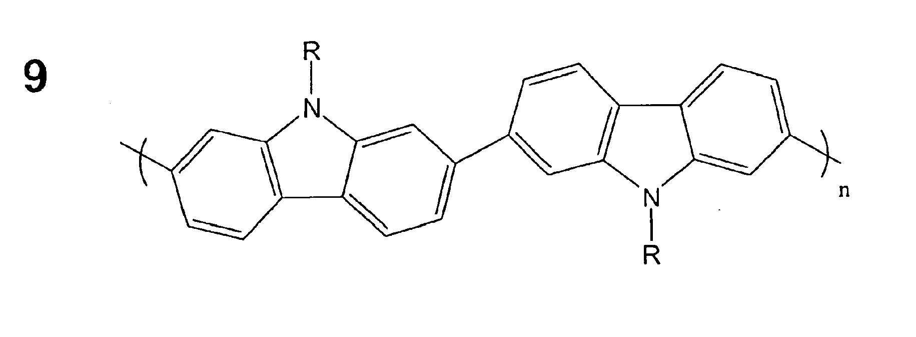 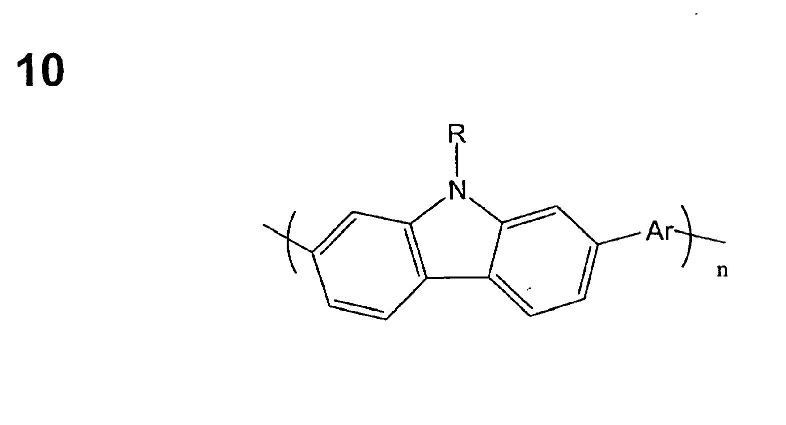 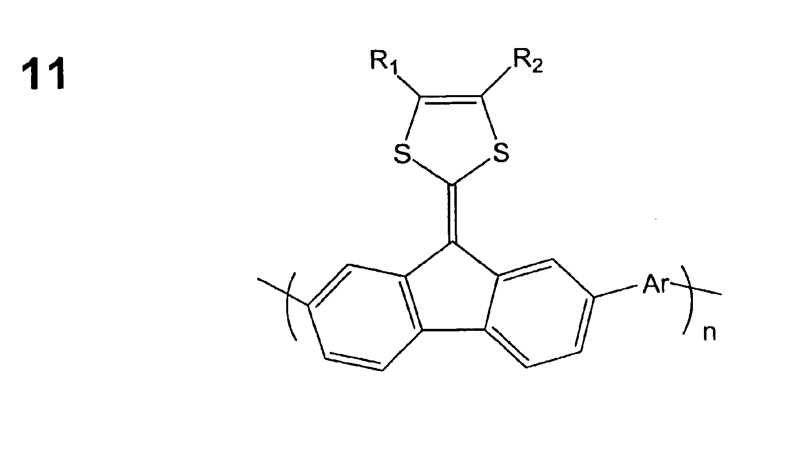 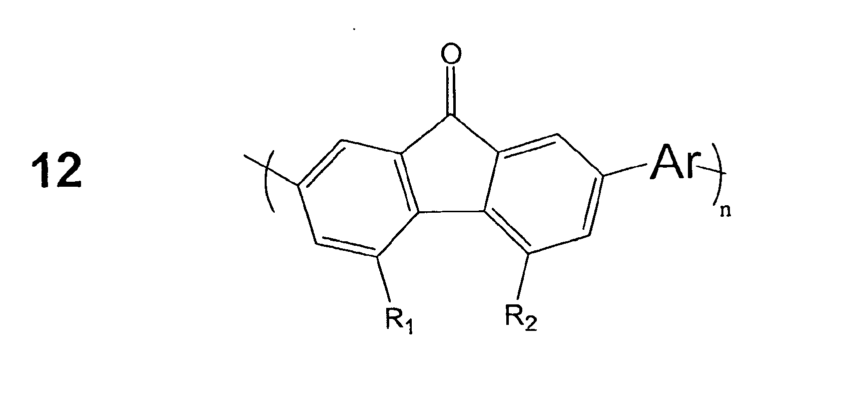 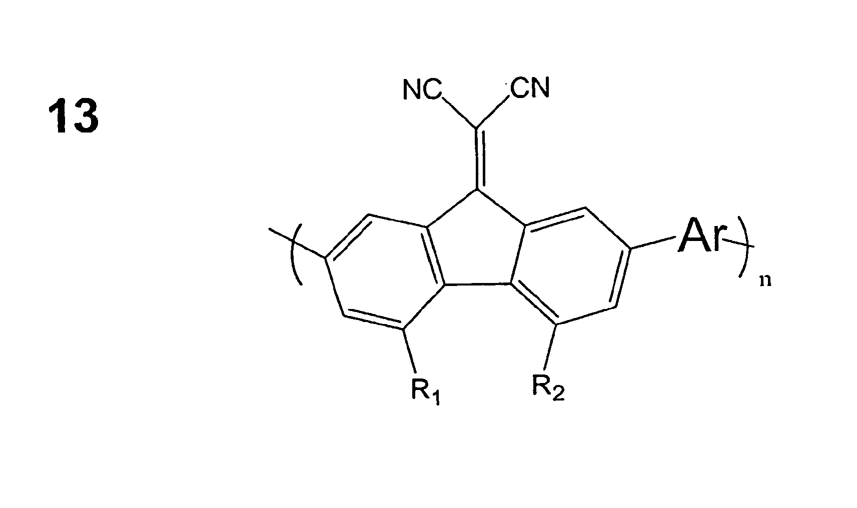 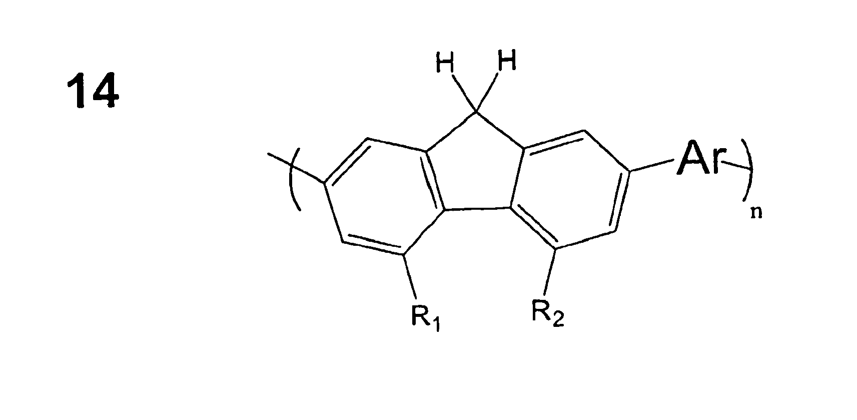 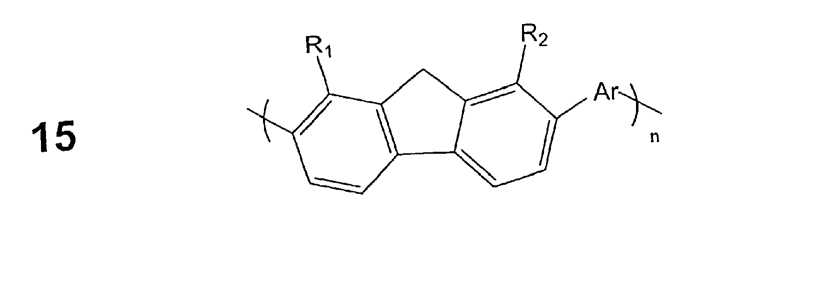 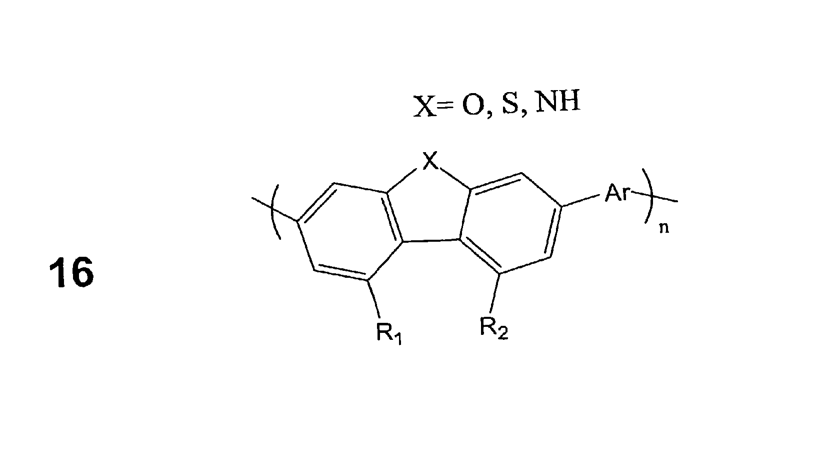 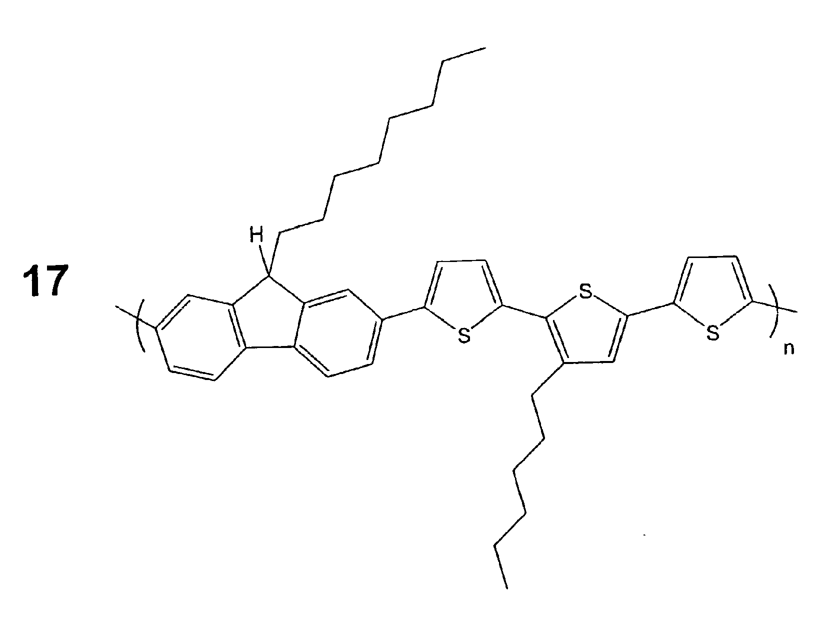 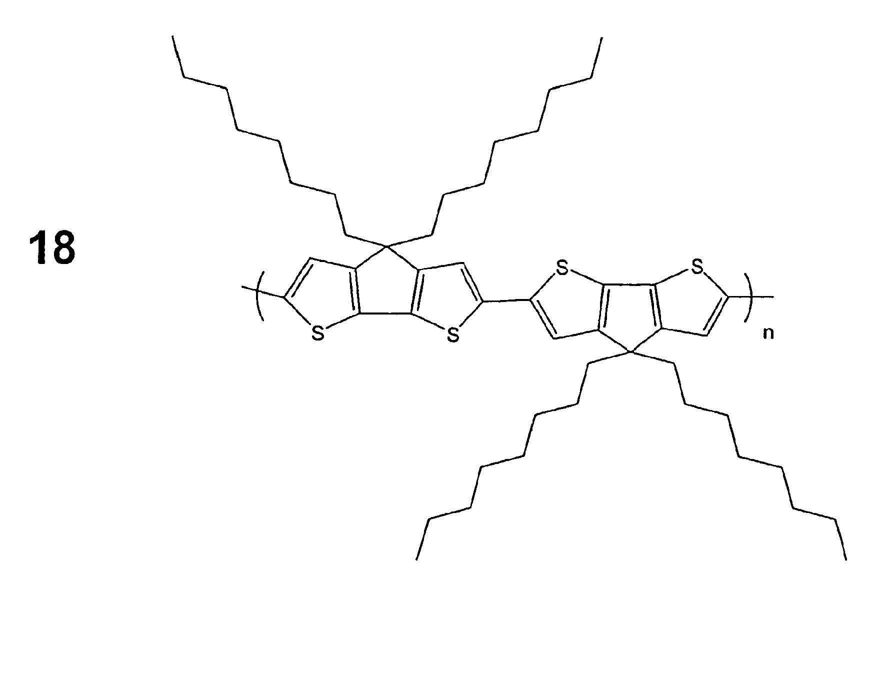 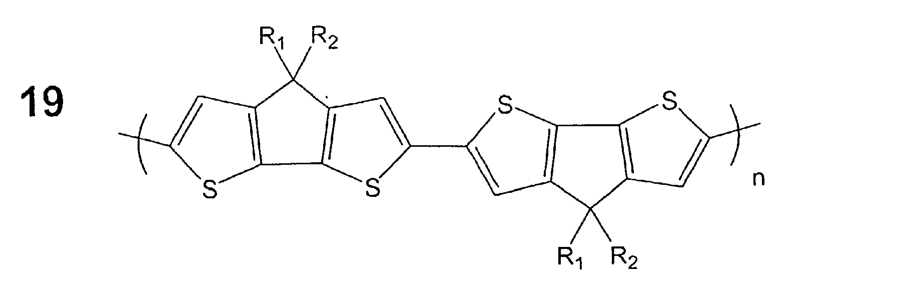 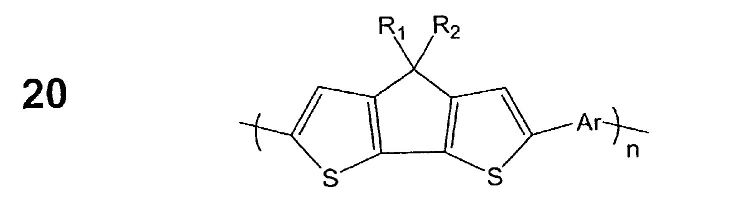 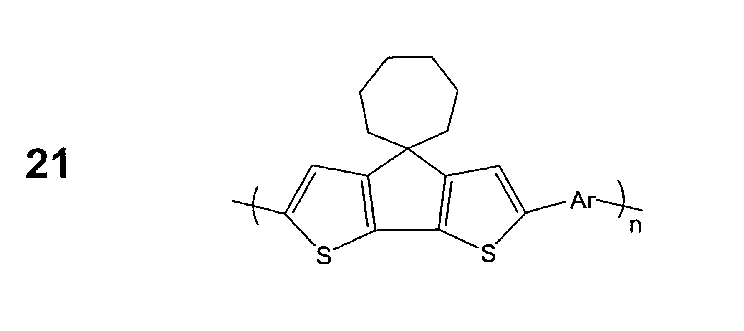 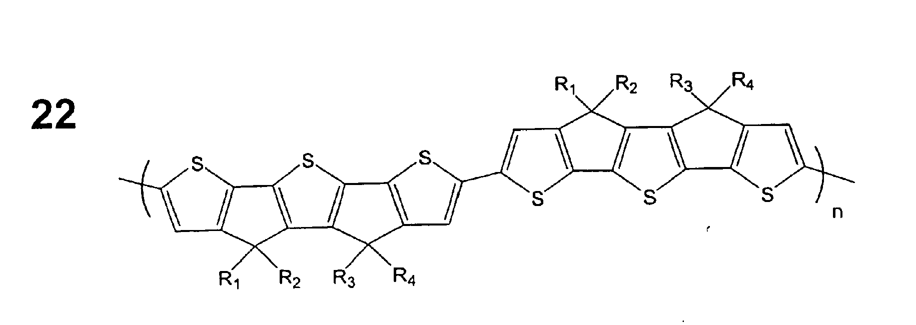 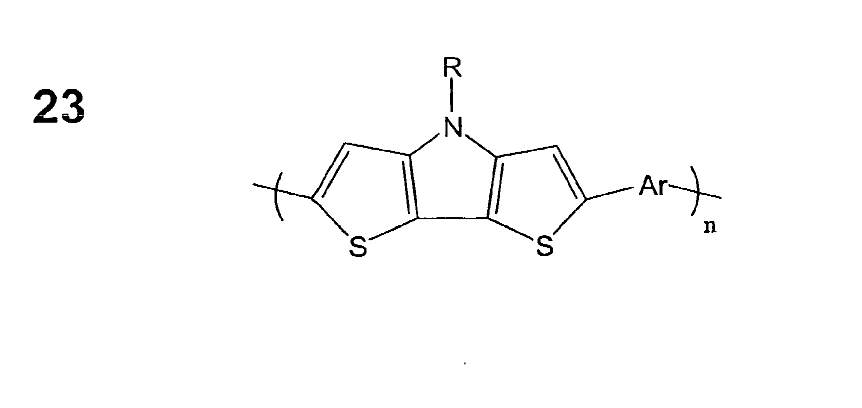 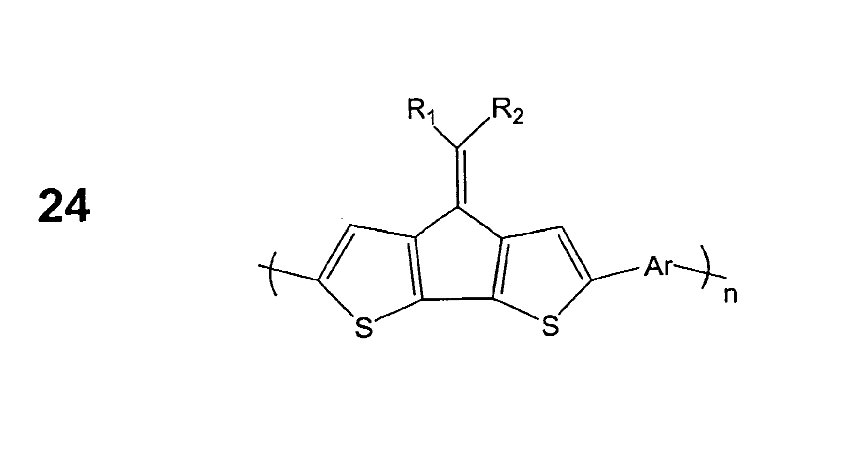 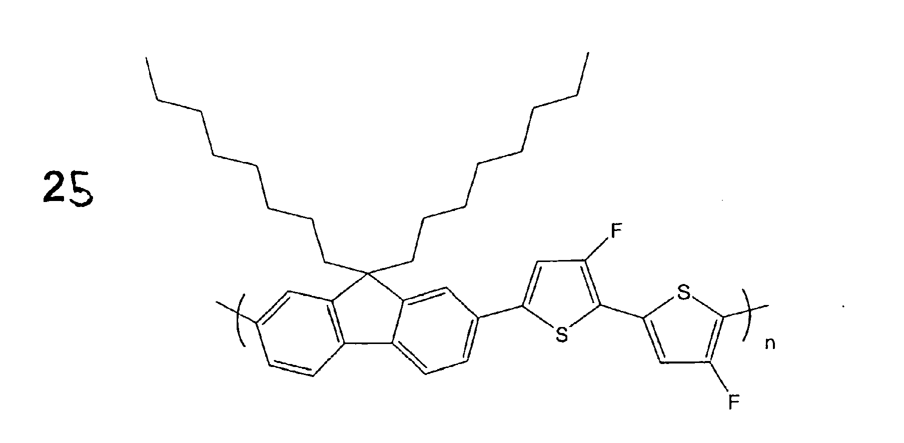 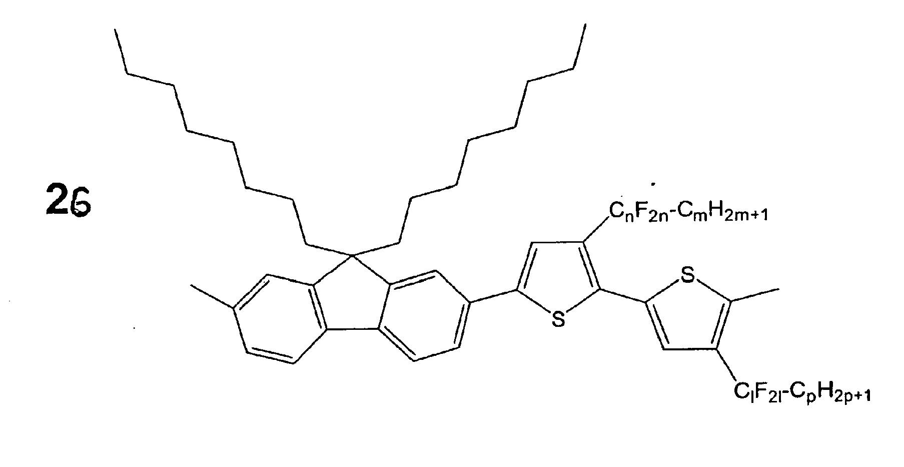 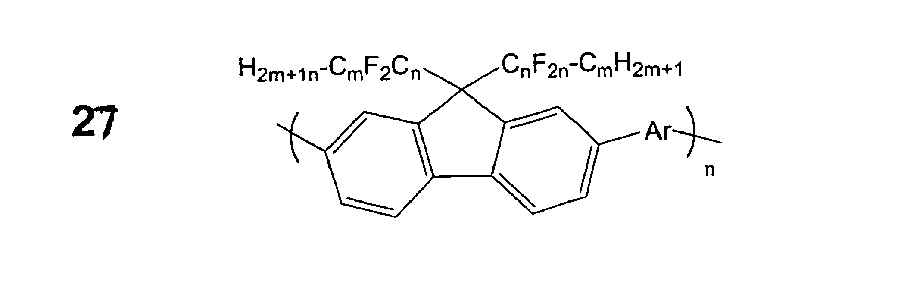 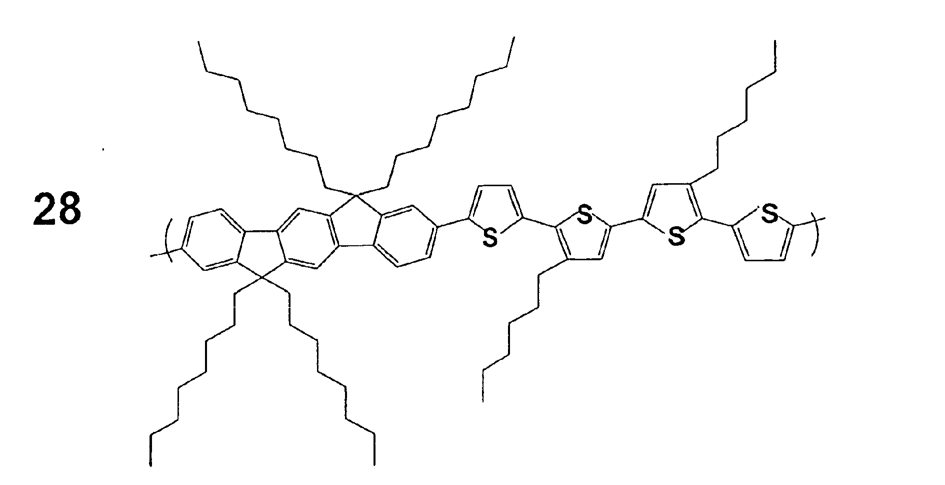 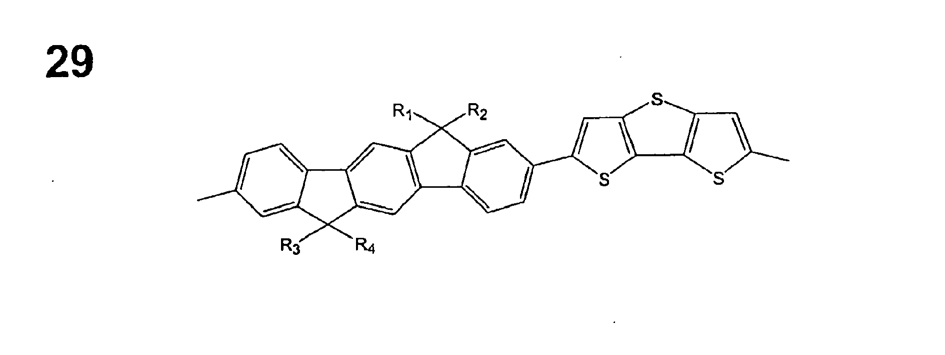 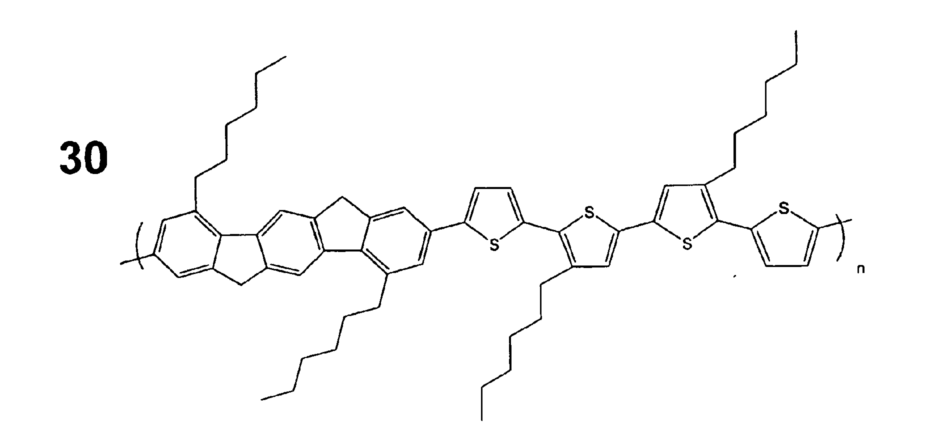 dans lesquelles :
n représente un nombre entier supérieur à 1 ; et
R, R1, R2, R3 et R4 peuvent être identiques ou différents dans chaque motif monomère dans le polymère et sont choisis indépendamment entre un atome d'hydrogène, des groupes alkyle et des groupes alkoxy ; et
Ar représente un groupe aromatique ou hétéroaromatique de transport de trous ou de transport d'électrons.

32. Procédé suivant la revendication 31, dans lequel les atomes d'hydrogène, les groupes alkyle ou les groupes alkoxy sont substitués avec un ou plusieurs atomes de fluor.

33. Procédé suivant la revendication 30, dans lequel le dispositif de commutation électronique fait partie d'un dispositif à circuit logique, dispositif d'affichage ou dispositif à mémoire.
